# EUROPÄISCHE PATENTSCHRIFT

(11) **EP 1 022 809 B1**
(45) Veröffentlichungstag und Bekanntmachung des Hinweises auf die Patenterteilung: **05.04.2006**
(21) Anmeldenummer: 00100539.6
(22) Anmeldetag: 12.01.2000
(51) Int. Cl.: H01R 9/26, H02B 1/20, H05K 7/14

(54) **Elektrisches Gerät**
Electrical apparatus
Appareil électrique

(30) Priorität: 25.01.1999 DE 19902745
(43) Veröffentlichungstag der Anmeldung: 26.07.2000
(73) Patentinhaber: Weidmüller Interface GmbH & Co., 32760 Detmold (DE)
(72) Erfinder: Zebermann, Christoph, 37688 Beverungen (DE); Pilgrim, Jens, 32602 Vlotho (DE); Wilmes, Manfred, 32760 Detmold (DE); Schnatwinkel, Michael, 32051 Herford (DE); Steinmeier, Rudolf, 32760 Detmold (DE); Hanning, Walter, 32758 Detmold (DE)
(74) Vertreter: Specht, Peter

(56) Entgegenhaltungen:
- EP-A- 0 709 933
- WO-A-99/23737
- DE-A- 4 303 717
- DE-A- 4 402 001
- DE-C- 4 410 171

## Beschreibung

Die Erfindung betrifft ein elektrisches Gerät mit modularem Aufbau zur Steuerung und/oder Überwachung technischer Prozesse und/oder zur Industrie- und/oder Gebäudeautomatisierung, mit wenigstens einem auf eine Tragschiene aufsetzbaren Anschlußmodul, das mit mehreren Ebenen von Anschlüssen zum Anschluß externer Leiter versehen ist und eine Aneinanderreihung aus scheibenförmigen Basis-Klemmenträgern aufweist, wobei innerhalb jedes Anschlußmodules im wesentlichen parallel zur Tragschiene ein interner Busleiter sowie mehrere Potentialführungen verlaufen, und wobei die Potentialführungen vorzugsweise über Stromschienen der scheibenförmigen Basis-Klemmenträger und ggf. über weitere Elemente mit den Anschlußebenen verbunden sind.

Ein derartiges elektrisches Gerät ist aus der EP 95 113 730 A1 bekannt. Bei dem in dieser Schrift gezeigten Gerät mit internem Busleiter dienen auf Tragschienen anreihbare Anschlußblocks zur Signalanpassung zwischen einem übergeordneten Feldbus und an die Anschlußblocks angeschlossenen Initiatoren, Feldgeräten oder dergleichen. Die Anschlußblocks sind aus funktionsverschiedenen Anschluß- bzw. Modulscheiben zusammengesetzt, wobei zwischen Schutzleiterscheiben, Einspeisescheiben, Versorgungs-/Signalleiterscheiben und Rastfußscheiben unterschieden wird. Ein oder mehrere Anschlußblocks sind über den internen Busleiter mit einem Anschlußmodul für einen Feldbus verbindbar.

Dieses elektrische Gerät hat sich zwar an sich bewährt. Wünschenswert ist jedoch eine weitere Vereinfachung des Aufbaus der einzelnen Anschlußscheibe und eine Reduzierung der Anzahl Anschlußscheiben verschiedenen Typs zum Aufbau eines Anschlußblockes bzw. Anschlußmodules.

Die Erfindung nimmt sich zunächst des Problems der Vereinfachung des Aufbaus der einzelnen Anschlußscheiben sowie einer generellen Verringerung der Abmessungen des Systems an.

Die Erfindung löst dieses Problem dadurch, daß die Stromschienen zur Potentialzuführung zu den Anschlußebenen auf die beiden Seiten des Basis-Klemmenträgers verteilt sind und die Stromschienen jedes einzelnen Potentiales nur jeweils auf einer der Seiten des Basis-Klemmenträgers zu den zugehörigen Anschlüssen geführt sind, wobei die mit einem gemeinsamen Potential zu versorgenden Anschlüsse direkt miteinander zu Mehrfachanschlüssen verbunden sind.

Durch diese konstruktiv einfach realisierbare Maßnahme ist es nicht mehr nötig, die zwei (beim Scheibenaufbau) oder mehr (beim Blockaufbau) einzelnen Anschlüsse jedes Mehrfachanschlusses jeweils einzeln über separate Stromschienen mit den gewünschten Potentialen zu versorgen. Sowohl das positive und das negative Potential als auch das Schutzleiterpotential können vielmehr jeweils über nur einen Stromschienenzweig auf einer der Seiten der Kunststoff-Grundscheiben zu den Mehrfachanschlüssen geführt werden, die dann miteinander in den jeweiligen Anschlußebenen direkt verbunden sind. Lediglich die Signalanschlüsse müssen zur Unterscheidung der Signale der angeschlossenen Geräte noch über separate Stromschienen von den Anschlußebenen zur Elektronik des Anschlußmodules geführt werden.

Die Erfindung nutzt die vorstehend beschriebene geschickte Stromschienenfiihrung insbesondere bei einem Modulsystem, welches auf dem überraschenden - auch unabhängig zu betrachtenden Gedanken beruht - daß jedes Anschlußmodul aus beliebig aneinanderreihbaren und miteinander kombinierbaren Modulscheiben und Modulblöcken besteht, die jeweils auf den aneinanderreihbaren Basis-Klemmenträgern aufbauen, wobei auch die Basis-Klemmenträger scheiben- oder blockartig auslegbar sind. Dem scheibenweisen Aufbau wird in den meisten Anwendungen der Vorzug gegeben. Dabei weisen die jeweiligen Basis-Klemmenträger der Modulscheiben und der Modulblöcke jeweils eine Elektronikleiterplatte, ein Elektronikgehäuse und ein Abdeckgehäuse auf. Ferner übergreifen die Elektronikleiterplatte, das Elektronikgehäuse und das Abddeckgehäuse der Modulblöcke jeweils mehrere und das Abdeckgehäuse sowie vorzugsweise die Elektronikleiterplatte und das Elektronikgehäuse der Modulscheiben jeweils nur einen der Basis-Klemmenträger. Dadurch, daß Modulscheiben und Modulblöcke im wesentlichen auf gleichen und kompatiblen Basiselementen aufbauen, ist es möglich, den Block- und den Scheibenaufbau beliebig miteinander zu kombinieren und zu mischen und je nach Anwendungsfall einen besonders preiswerten Anschlußmodul-Aufbau zu realisieren. Dies löst insbesondere das Problem, daß ein reiner Blockaufbau bei einer größeren Anzahl von Anschlußgeräten gleicher Auslegung zu Kostenvorteilen führt, wogegen er bei wenigen - und darüberhinaus verschiedenen - externen Geräten zu Kostennachteilen führen kann. Mit der Erfindung ist es möglich, jeweils die für den Anwendungsfall günstigste Kombination aus Block- und Scheibenaufbau zu wählen, wobei die gemeinsamen Basiselemente sowohl des Block- als auch des Scheibenaufbaus jeweils die stabilen und leicht handhabbaren Basis-Klemmenträger zur Aufnahme der Elektronikleiterplatte sind. Alternativ ist es auch denkbar, daß jeweils eine der Elektronikleiterplatten und eines der Elektronikgehäuse mehrere der aneinandergereihten Modulscheiben übergreifen und/oder daß mehrere Elektronikleiterplatten in die Elektronikgehäuse der Modulblöcke eingesteckt sind.

Denkbar ist es auch, daß der Modulblock, insbesondere dessen Basis-Klemmenträger, aus einem Unterteil und darauf aufgesetzten Scheibenelementen besteht.

Die besonders vorteilhafte Stromschienenführung der Erfindung läßt sich unproblematisch dadurch realisieren, daß die Stromschienen für das positive und das negative Potential sowie weitere Stromschienen zur Signalübertragung in seitliche Ausnehmungen des Basis-Klemmenträgers eingesetzt sind, welche von den Anschlußebenen mit den Doppel- oder Mehrfachanschlüssen zu Anschlußöffnungen zur Aufnahme eines Gerätesteckers zur Elektronikleiterplatte und/oder des Randes der Elektronik-Leiterplatte in der Grundwandung der Ausnehmung der Basis-Klemmenträger verlaufen.

Eine weitere Reduzierung der Teilezahl bei der Erfindung wird dadurch erreicht, daß die Stromschiene zur Verbindung der Schutzleiter-Potentialführung mit der Anschlußebene für das Schutzleiterpotential vorzugsweise einstückig an die Querbrücker der Schutzleiter-Potentialfiihrung angeformt ist. In diesem Sinne ist es auch vorteilhaft, wenn die Endbereiche der Stromschienen (auch FE-Kontakt) als Anschlußkontakte zum Anschluß weiterer Stromschienen oder Leiterplattenränder und/oder wenn die Endbereiche der Stromschienen wenigstens an einer Seite als Stanz-/Biegeteil-Aufnahmekontakte für den Gerätestecker zur - oder den Rand der - Elektronik-Leiterplatte ausgebildet sind.

Werden mehr als vier Anschlußebenen gewünscht, ist dies auf einfache Weise dadurch realisierbar, daß an die Stromschienen separate oder einstückig mit diesen ausgebildete Verlängerungs-Stromschienen zur Brückung der Potentiale zwischen den verschiedenen Anschlußebenen der Basis-Klemmenträger angesetzt werden. Diese werden insbesondere jeweils um 90° verdreht an die jeweils zu verlängernden Stromschienen angesetzt und vorzugsweise an einem ihrer Enden federnd ausgeführt, wobei die federnden Abschnitte in Öffnungen der jeweils zu verlängernden Stromschienen eingreifen. Alternativ ist es zweckmäßig, wenn die Verlängerungsstromschienen mit ihren Endbereichen in federnde Aufnahmebuchsen der jeweils zu verlängernden Stromschienen eingreifen.

Eine weitere - auch unabhängig betrachtbare - besonders vorteilhafte Variante der Erfindung zeichnet sich dadurch aus, daß die Weiterleitung der verschiedenen Potentiale innerhalb der Modulblöcke einerseits durch die Potentialführungen im unteren zur Tragschiene gewandten Bereich der Basis-Klemmenträger und andererseits zwischen den Mehrfachanschlüssen einer Anschlußebene durch Querverbinderkämme erfolgt, die mit Zapfen versehen sind, welche in an die Stromschienen angeformte federnde Aufnahmebuchsen eingreifen. Durch die Querverbinderkämme entfällt bei einem Modulblock die Notwendigkeit, in jedem Basis-Klemmenträger separate - ggf. auch verschieden lange - Stromschienen zu den Anschlußebenen zu führen. Die Potentialeinspeisung erfolgt beispielsweise nur einmal, wenn die Belegung innerhalb des Modulblockes über den ganzen Modulblock hinweg einheitlich bleibt. Lediglich die Signalebenen sind noch individuell über die Klemmenträger mit der Elektronik des Modulblockes zu verbinden. Dadurch wird der konstruktive Aufbau des Modulblocks vereinfacht und die Idee der möglichst einfachen Stromschienenführung am Klemmenträger der Modulscheiben mit Doppelanschlüssen in Richtung eines Mehrfach-Anschlußsystemes für die Modulblöcke weiter entwickelt. Die Querverbinderkämme reduzieren ferner die Steck-und Ziehkräfte beim Abnehmen/Aufstecken der Elektronik.

Auch am Modulblock ist die Idee der Verlängerungsstromschienen realisierbar. Vorzugsweise sind diese jeweils um 90° verdreht und an ihren Enden senkrecht nach oben mit Aufnahmebuchsen zur Kontaktierung der Querverbinderkämme versehen. Zweckmäßig sind die um 90° verdrehten Verlängerungsstromschienen von gesondert einlegbaren und/oder am Basis-Klemmenfrägern angespritzten Isolierscheiben von dem Potential der Stromschienen anderer Anschlußebenen luft- und kriechstreckenseitig getrennt. Zweckmäßig ist ferner der PE-Querbrücker bei den Modulblöcken senkrecht in den seitlichen Ausnehmungen der Basis-Klemmenträger angeordnet und weist an seinen Enden eine Aufnahmebuchse zur Kontaktierung der Querverbinderkämme und eine Aufnahmebuchse zur Kontaktierung der PE-Stromschiene auf.

Die Idee der Querverbinderkämme wird auch in Richtung einfacher Montage des Modulblockes konsequent dadurch fortgeführt, daß die Querverbinderkämme in das Abdeckgehäuse eingesteckt sind und beim Aufsetzen des Abdeckgehäuses auf die aneinandergereihten Basis-Klemmenträger des Modulblockes in die Basis-Klemmenträger eingreifen und jeweils wenigstens einen Kontaktabschnitt der Mehrfachanschlüsse ausbilden. Vorzugsweise wird ferner das Potential innerhalb einer Anschlußebene eines Modulblockes durch mehrere unterschiedliche lange Querverbindungskämme und beliebig in seitliche Ausnehmungen der Basis-Klemmenträger positionierbare Verlängerungsstromschienen variiert. Bei einem Modulblock wird ferner bevorzugt die Elektronik-Leiterplatte mit dem Modulblock über den ersten Basis Klemmenträger des Modulblockes verbunden.

Eine vorteilhafter Aufbau des elektrischen Gerätes mit einer vom Anwender leicht zu übersehenden Systematik ergibt sich durch das vorgesehene Gateway mit einfacher Gehäusegestaltung zum Anschluß eines externen Feldbusses, an das sich stets zunächst eine als Modulscheibe ausgelegte Einspeisescheibe anschließt. Zur Vermeidung einer separaten Energieversorgung des Gateways ist vorgesehen, daß die Strom- und Spannungsversorgung des Gateways und die der Anschlußmodule über die an das Gateway angereihte Einspeisescheibe erfolgt. Das Gateway ist derart ausgelegt, daß es direkt an den Basis-Klemmenträger und den internen Busleiterabschnitt der Einspeisescheibe ankoppelbar ist. Komplettiert wird das Modulsystem der Erfindung durch eine Abschlußplatte, vorzugsweise mit einem einschiebbaren, separaten Endwinkel.

Eine weitere vorteilhafte Variante der Erfindung zeichnet sich dadurch aus, daß jeweils die letzte Modulscheibe des Anschlußmodules des elektrischen Gerätes, vorzugsweise deren EA-Modulgehäuse, mit einem Anschluß oder Stecker zur Weitergabe des internen Busleiters und/oder der Potentiale an eine weitere Modulscheibe gleichen Aufbaus versehen ist, insbesondere für weitere Anschlußmodule des elektrischen Gerätes ohne eigenes Gateway, die sich auf einer anderen Tragschiene befinden. Damit ergibt sich die überraschende Möglichkeit dazu, mehrere Anschlußmodule mit nur einem einzigen Gateway zu betreiben und die Kosten des Systemes weiter zu senken.

Alternativ ist es schließlich auch denkbar, die signalführenden Stromschienen durch Lichtleiterelemente zu ersetzen.

Weitere vorteilhafte Ausführungsformen der Erfindung sind den übrigen Unteransprüchen zu entnehmen.

Nachfolgend wird die Erfindung unter Bezug auf die Zeichnung anhand von Ausführungsbeispielen näher beschrieben. Es zeigt:
- Fig. 1a - d: schematische Darstellungen des funktionalen Aufbaus von Anschlußmodulen erfindungsgemäßer elektrischer Geräte;
- Fig. 2: eine weitere schematische Darstellung des funktionalen Aufbaus eines erfindungsgemäßen elektrischen Gerätes;
- Fig. 3a: eine Sprengansicht einer ersten Ausführungsform einer Modulscheibe mit drei Anschlußebenen;
- Fig. 3b-d: verschiedene Ansichten des Basis-Klemmenträgers nebst Stromschienen zur Modulscheibe aus Fig. 3a;
- Fig. 3e: eine Ansicht der Elektronikleiterplatte für die Modulscheibe der Fig. 3a mit einem Beispiel eines direkt an die Leiterplatte angesetzten Gerätesteckers;
- Fig. 4a: eine schematische Sprengansicht einer zweiten Ausführungsform einer Modulscheibe mit vier Anschlußebenen;
- Fig. 4b-d: verschiedene Ansichten des Basis-Klemmenträgers der Modulscheibe aus Fig. 4a;
- Fig. 5a: eine schematische Sprengansicht einer dritten Ausführungsform einer Modulscheibe mit sechs Anschlußebenen;
- Fig. 5b-d: verschiedene Ansichten des Basis-Klemmenträgers der Modulscheibe aus Fig. 5a;
- Fig. 5e, f: zwei Stromschienenanordnungen für Modulscheiben mit sechs Anschlußebenen;
- Fig. 6: eine Seitenansicht eines weiteren Ausführungsbeispiels der Erfindung;
- Fig. 7a: verschiedene Ansichten von Elementen eines Modulblockes nach einem weiteren Ausführungsbeispiel der Erfindung;
- Fig. 7b: eine Stromschienenanordnung für den Modulblock aus Fig. 7a;
- Fig. 7c,d: verschiedene Ansichten von Elementen des Modulblockes aus Fig. 7a;
- Fig. 8: eine Sprengansicht von Elementen eines Gateways;
- Fig. 9a,b: Sprengansichten einer zweiten Ausführungsform eines Gateways;
- Fig 10a, b: eine Modulscheibe nach Art der Fig. 3 mit aufgesetztem Elektronikgehäuse; und
- Fig. 11a, b: zwei Kontaktelemente für einen Modulblock nach Art der Fig. 7.

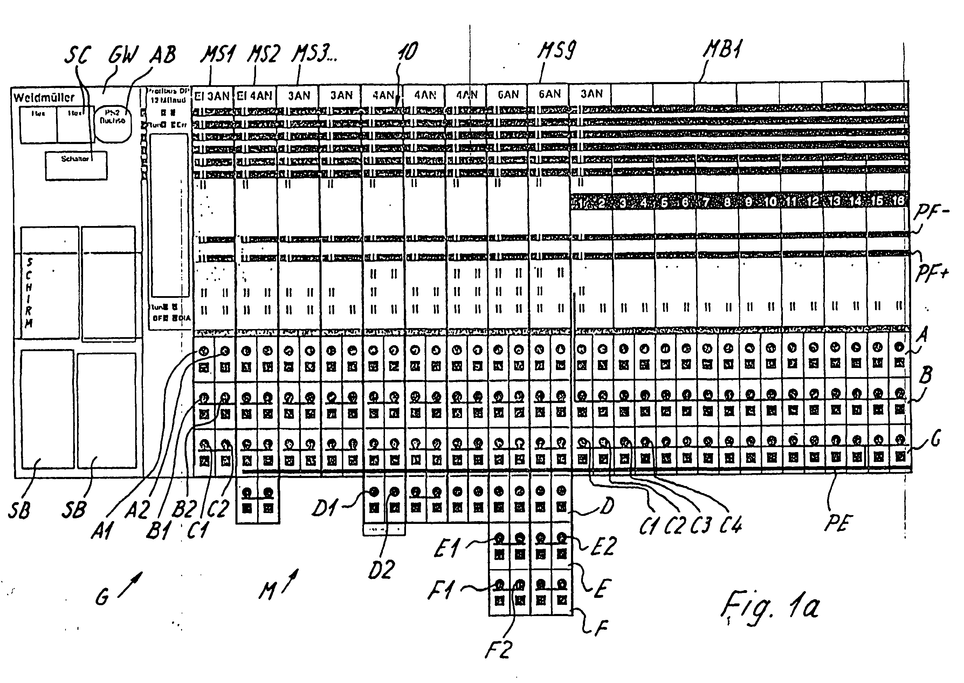

Fig. 1a bis 1d zeigen schematische Darstellungen von verschiedenen auf eine Tragschiene aufsetzbaren elektrischen Geräten G der Automatisierungstechnik. Das Gerät G umfaßt ein Gateway GW, an welches Anschlußmodule M in Scheibenform (Modulscheiben MS) und/oder Blockform (Modulblöcke MB1 - MB3) anreihbar sind. Das elektrische Gerät G ermöglicht die Überwachung und/oder Steuerung externer elektrischer Geräte (Feldgeräte, Initiatoren, Aktoren usw.), welche an die Anschlußmodule des erfindungsgemäßen elektrischen Gerätes anschließbar sind.

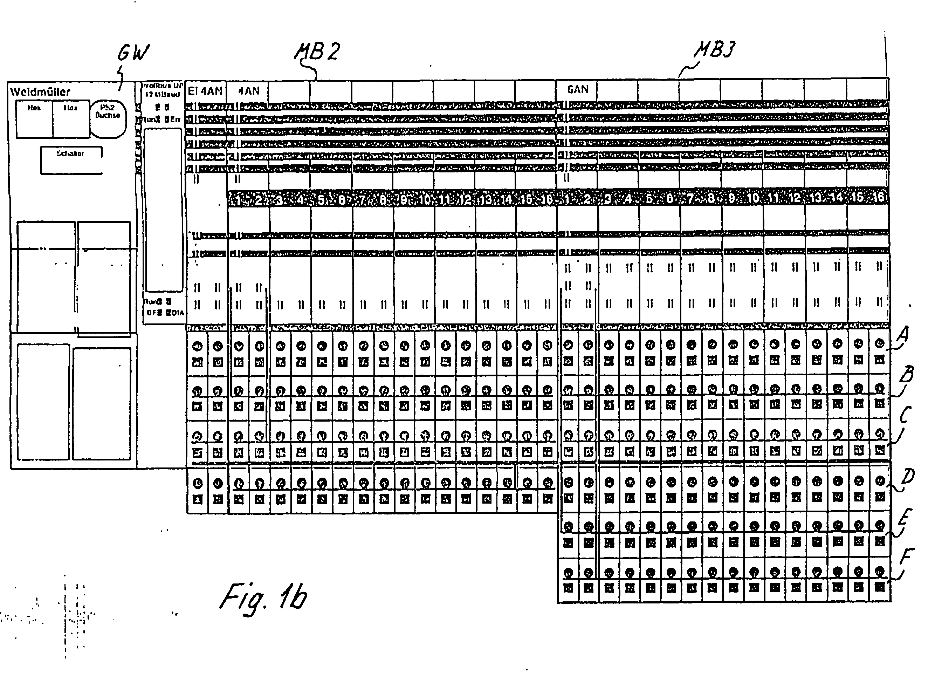

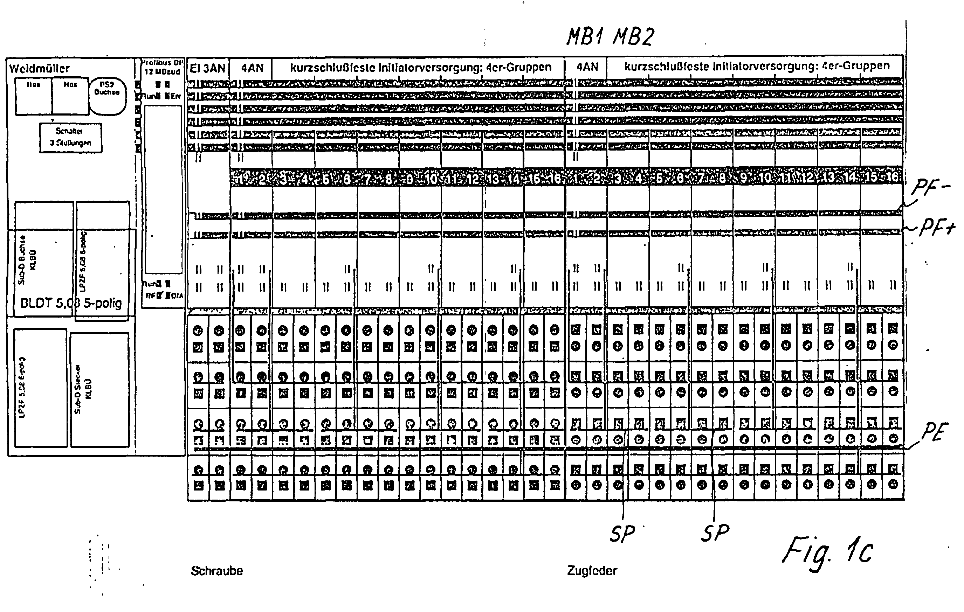

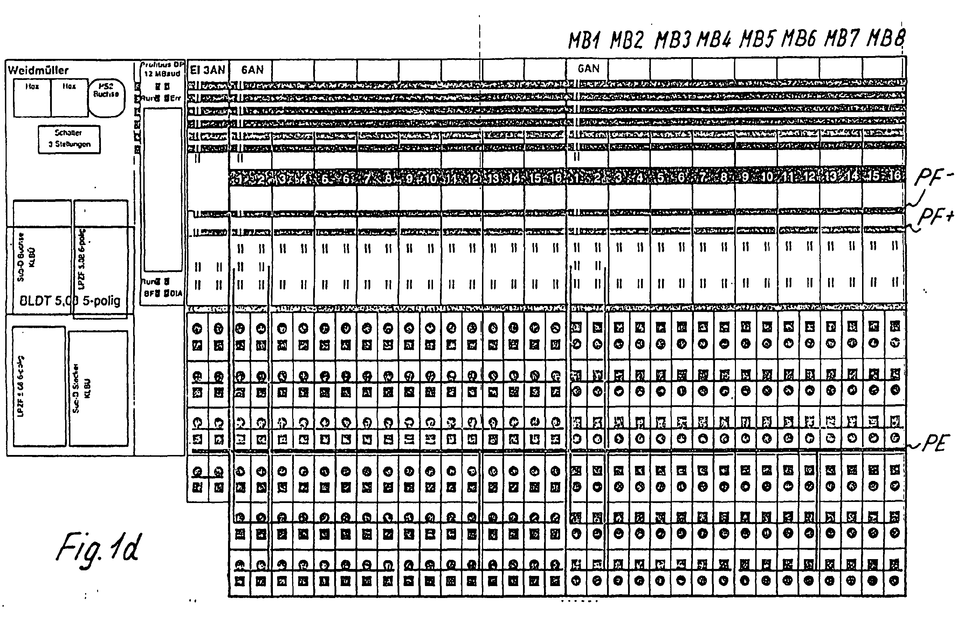

Das Gateway GW verfügt über eine hier nicht dargestellte Elektronik und ist mit Anschlußelementen SB zum Anschluß verschiedenster externer Feldbussysteme zur Weitergabe an einen internen Busleiterabschnitt 10 sowie mit weiteren Anschlüssen/Diagnoseschittstellen AB (z.B. PS2-Buchse, Schirm, Stiftleisten) und Schalter(n) SC versehen. An das Gateway GW schließen sich in der Version der Fig. 1 die Anschlußmodule M verschiedener Art an, die je nach Auslegung entweder zum Anschluß bestimmter externer elektrischer Geräte (Anschlußmodulscheibe) oder aber zur Potentialeinspeisung in das System (Einspeise-Modulscheibe) ausgelegt sind.

Die erste sich an das Gateway anschließende Modulscheibe MS1 mit der Bezeichnung "EI3AN" dient zur Einspeisung von elektrischen Potentialen über die Anschlüsse A1, A2 bis C2 in das elektrische Gerät, wobei diese Potentiale von den Anschlüssen A1, A2, ... über Stromschienen und ggf. Leiterbahnen (hier nicht dargestellt) in das Gateway und/oder über Potentialführungen PF-, PF+ in weitere Modulscheiben MS und/oder Modulblöcke MB geleitet werden. Analoges gilt für die zweite angereihte Modulscheibe MS2 (EI4AN), welche aufgrund der größeren Zahl von Anschlüssen für externe Leiter die Einspeisung von mehr verschiedenen elektrischen Potentialen in das System erlaubt, insbesondere die Einspeisung eines zusätzlichen Schutzleiterpotentiales über die vierte Anschlußebene D zur Potentialführung PE. An ein einzelnes Gateway muß sich nur jeweils eine der beiden Einspeisescheiben MS1 oder MS2 anschließen, die beiden dargestellten Varianten dienen lediglich zur Veranschaulichung verschiedener Ausführungsformen von Einspeisescheiben. An die Einspeisescheiben schließen sich weitere Modulscheiben MS3 bis MS9 an (Anschlußmodulscheiben), die jeweils die Bezeichnung 3AN , 4AN oder 6AN tragen, was andeutet, daß drei, vier oder sechs der Anschlußebenen A, B, C, ... zum Anschluß externer Leiter vorgesehen sind, wobei die einzelnen Anschlüsse beispielsweise in Schraub- oder Zugfedertechnologie ausgeführt sein können. Zur Potentialeinspeisung und/oder neuerlichen Systemversorgung können weitere Einspeisescheiben MS1, MS2 zwischen die Anschlußscheiben MS3, MS4, MS5 ... gesetzt werden. Analoges gilt für die Modulblöcke MB1 bis MB3 mit drei, vier oder sechs Anschlußebenen mit Mehrfachanschlüssen B1, B2, B3, B4, ....

Jede der Modulscheiben weist zwei Reihen von Anschlüssen A1, B1, ... bzw. A2, B2 usw. auf. Die Anschlußebenen A und ggf. auch D weisen Einzelanschlüsse A1, A2, D1, D2 zur Signalübertragung zu/von den extern angeschlossenen Geräten auf. Jede der weiteren Anschlußebenen B, C, E, F und ggf. auch D der Modulscheiben MS ist zur Potentialweiterleitung mit durchkontaktierten Doppelanschlüssen (bzw. beim Blockaufbau: Mehrfachanschlüsse B1, B2, B3, ...) versehen, so daß pro Modulscheibe MS in jeder Anschlußreihe ein oder zwei (oder bei besonderen Ausführungsformen auch mehr) externe elektrische Geräte anschließbar sind. Die verschiedene Anzahl von Anschlußebenen ermöglicht es, je nach Art des anzuschließenden Gerätes eine Modulscheibe MS mit nur so viel Anschlüssen einzusetzen, wie sie bei dem jeweiligen Gerät unbedingt benötigt werden. So sind z.B. bei einem Aktor - je nach dem ob positiv oder negativ schaltend - nur die folgenden drei Anschlüsse notwendig: 1. Signal S, 2. Minus "-" (oder Plus "+") und 3. Schutzerde "PE". Diese Aufgabe ist mit einer der Anschlußklemmen mit der Bezeichnung "3AN" lösbar. Werden weitere Anschlüsse notwendig oder sollen vier Geräte pro Modulscheibe MS angeschlossen werden, wird dagegen eine Anschlußklemme mit vier oder sechs Anschlußebenen ausgewählt. Ist eine ganze Reihe von externen elektrischen Geräten mit gleichen Anschlüssen zu überwachen, empfiehlt sich der Einsatz eines Modulblockes MB nach Art des rechten Teiles der Fig 1a oder der Fig. 1b, der an die Modulscheiben MS beliebig reihbar und mit allen Anschlußbelegungen der Modulscheiben MS3 bis MS9 realisierbar ist, also selbst drei, vier oder sechs Anschlußebenen mit einer vorgegebenen Belegung (z.B. A=Signal, B=Minus, C=PE usw.) aufweisen kann.

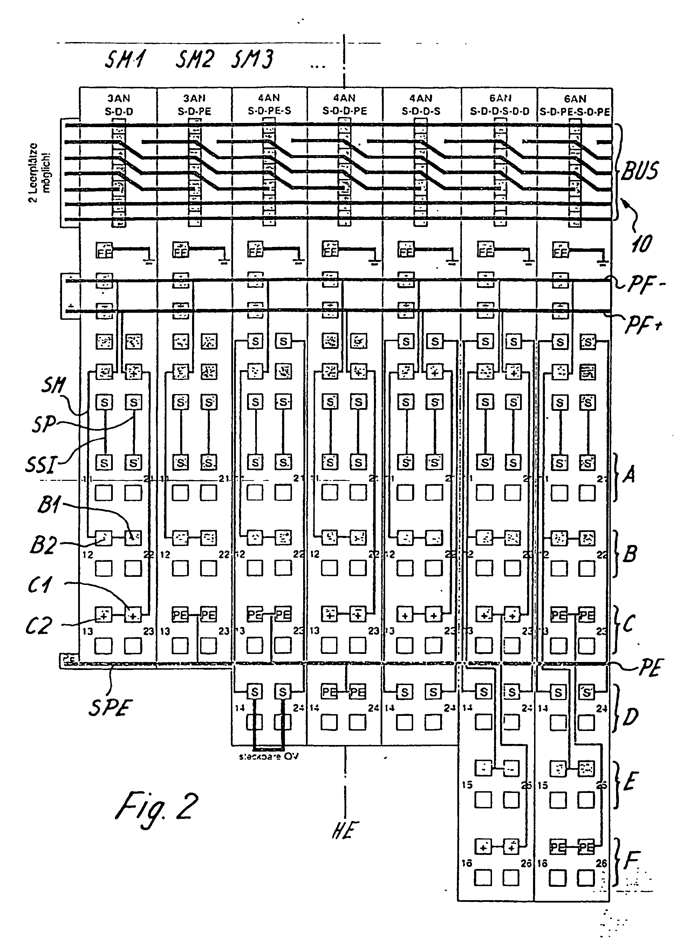

Die verschiedenen Anschlußscheiben mit einer gemeinsamen Anzahl von Anschlußebenen können sich voneinander durch die Art der Potentialbelegung unterscheiden. Dies wird besonders gut aus Fig. 2 deutlich. Die Anschlußebene A dient i.allg. als Signalebene (Signalanschlüsse S). Die zweite Anschlußebene B wird dagegen bei plusschaltenden Initiatoren und Aktoren mit einem negativen Potential belegt (-). In der dritten Anschlußebene wechseln je nach Anwendungsfall das positive Potential +, die Schutzerde PE oder der Schirm. Bei Ausführungen mit mehr als drei Anschlüssen kann die vierte Ebene D als Signal- oder Schutzleiter-Anschlußebene dienen. In der fünften und sechsten Ebene liegen - wiederum bei plusschaltenden Aktoren und Intiatoren - das negative und das positive Potential oder das negative Potential und die Schutzerde. Bei negativ schaltenden Aktoren und Initiatoren wird das negative Potential durch ein positives Potential ersetzt.

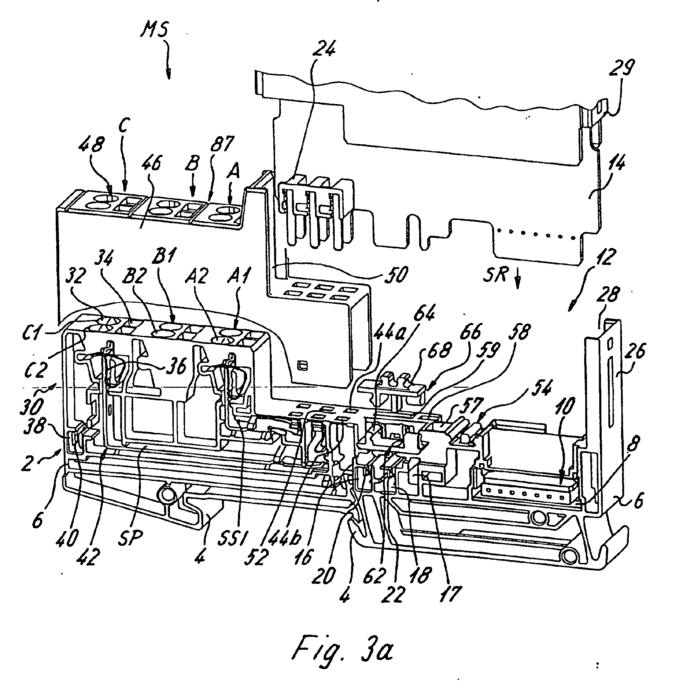

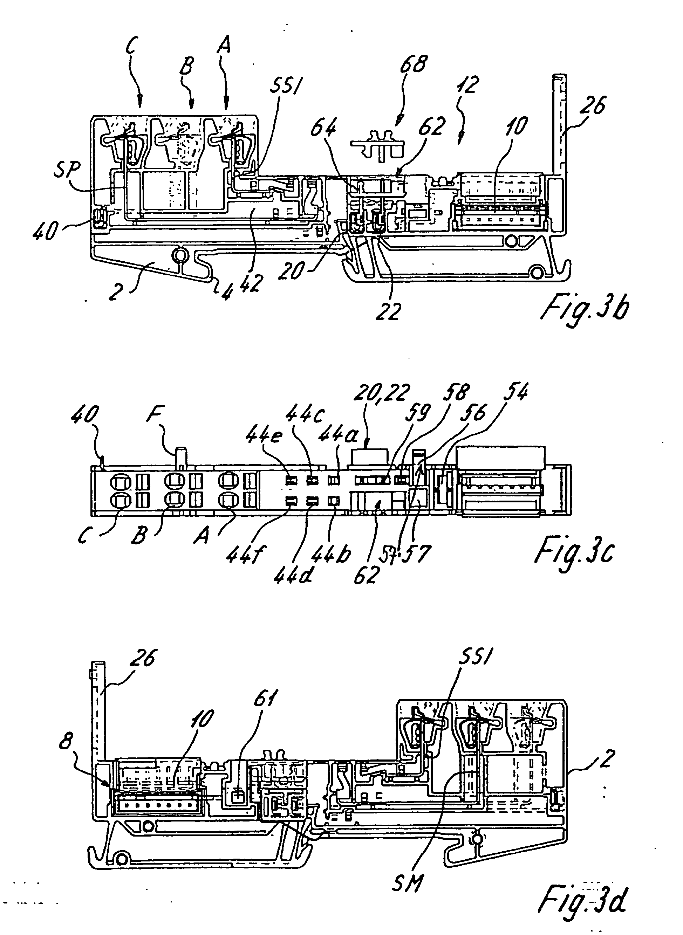

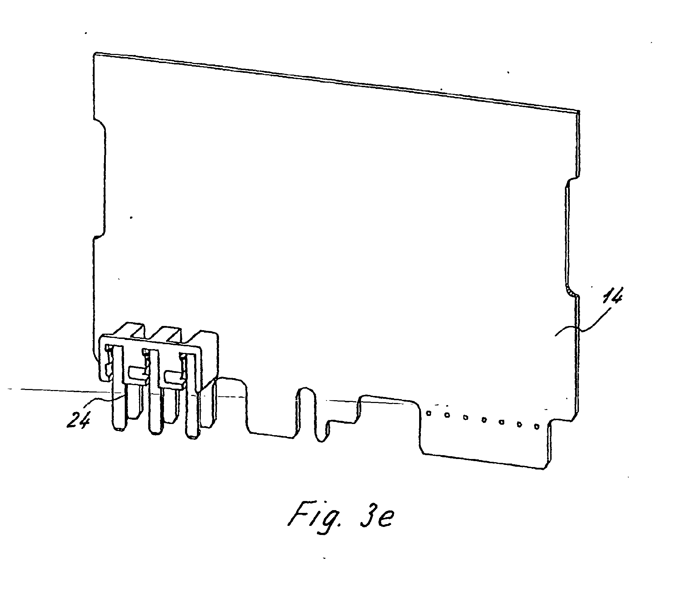

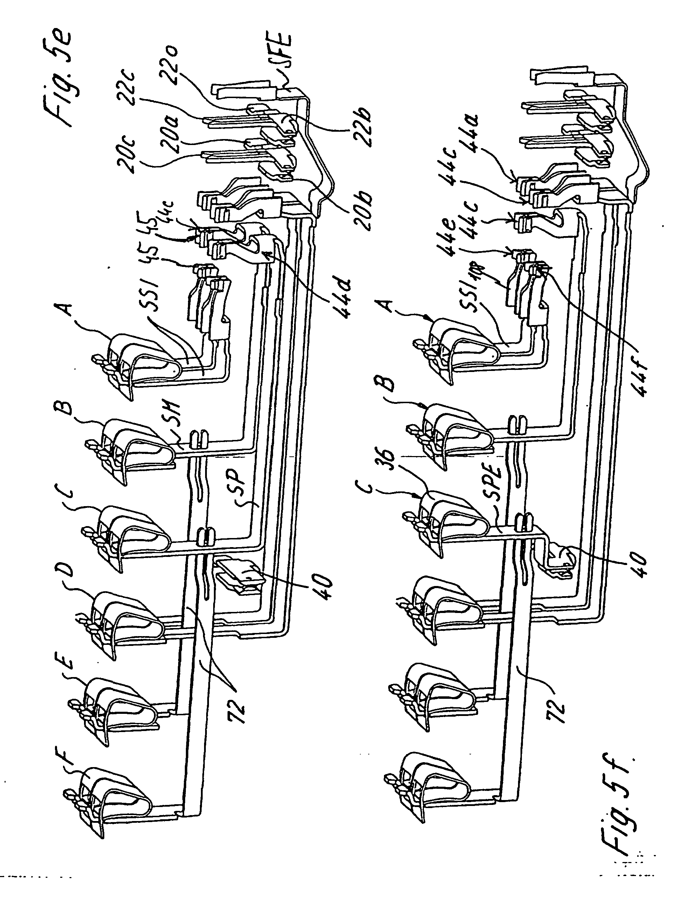

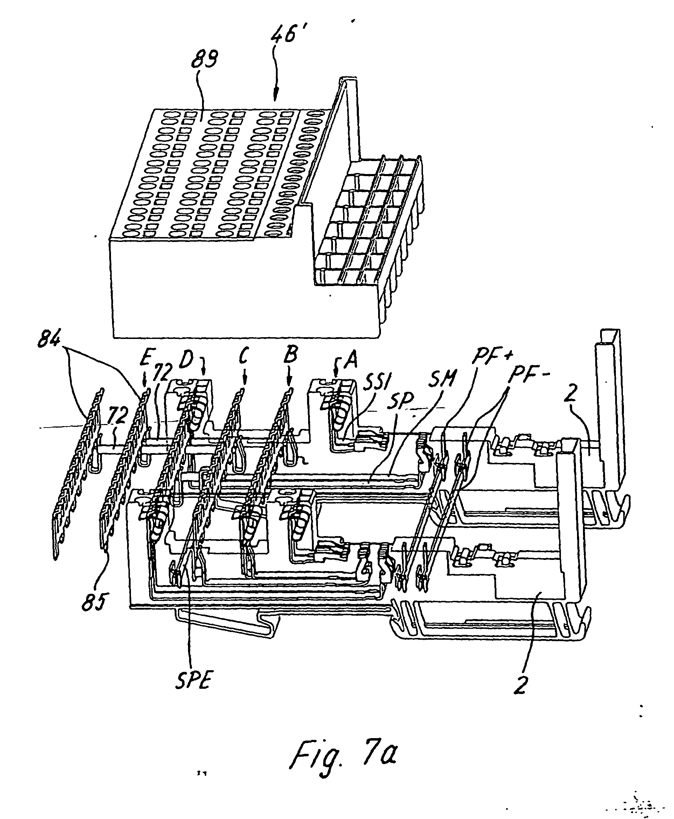

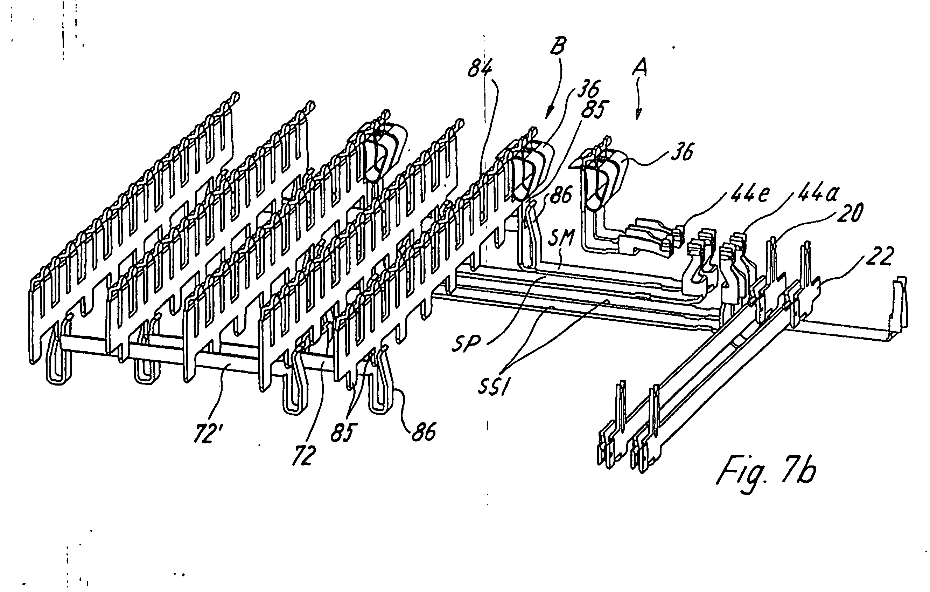

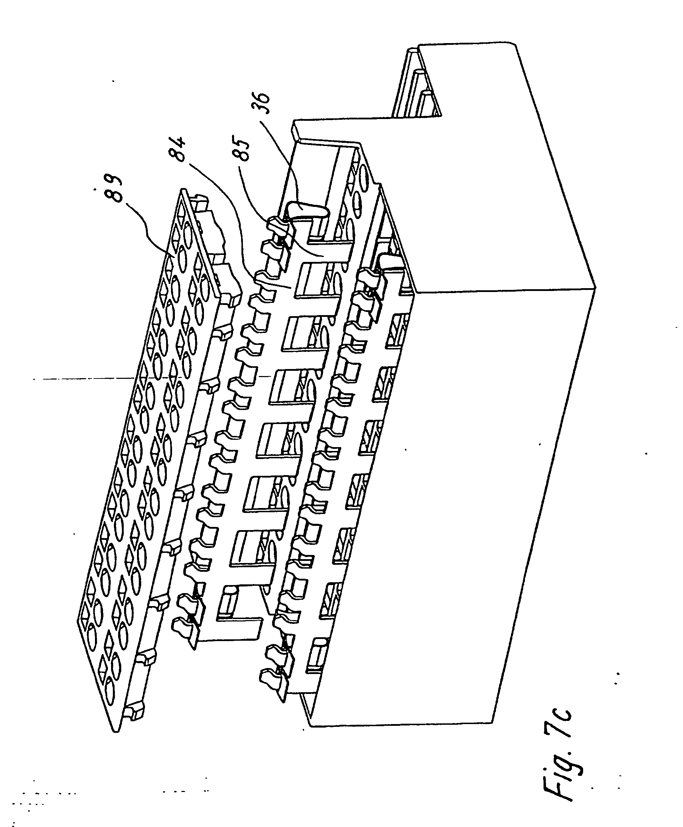

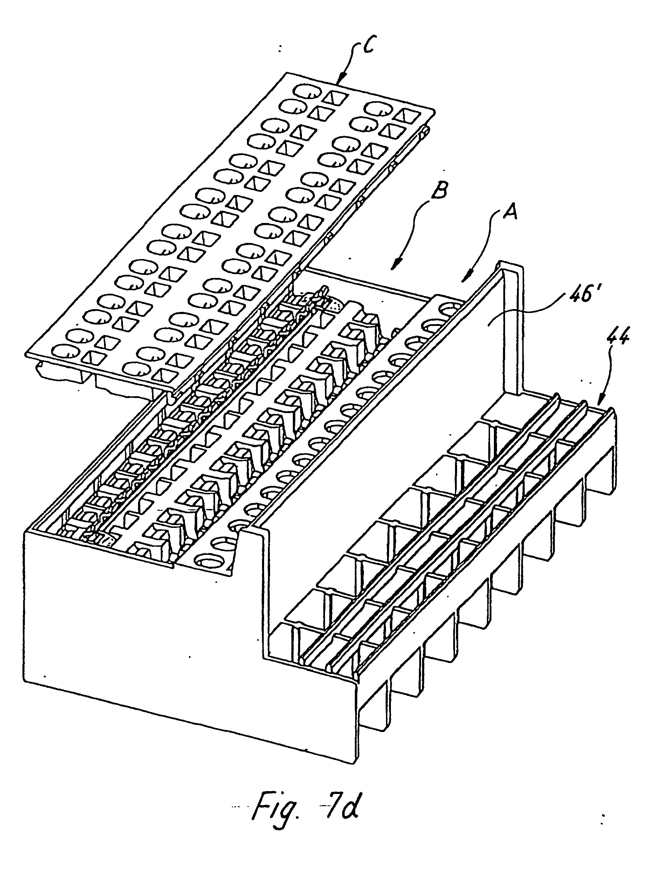

Wie bereits erwähnt und auch in Fig. 2 dargestellt, erfolgt von Modulscheibe zu Modulscheibe die Weiterleitung verschiedener elektrische Potentiale. Insbesondere das Minuspotential -, das Pluspotential + und der Schutzleiter PE werden von Modulscheibe zu Modulscheibe mittels der Potentialführungen PF-, PF+ und PE weitergeleitet. Von diesen Potentialführungen werden die Potentiale - beispielsweise Sicherheitskleinspannungen, aber auch Wechselspannungen - abgegriffen und den Anschlußebenen B bis F entweder direkt (PE) oder indirekt (PF+, PF-) über eine Elektronikleiterplatte zugeführt (siehe Beschreibung zur Fig. 3). An den Anschlußebenen B bis F können die Potentiale dann zur Versorgung der externen elektrischen Geräte abgegriffen werden. Das positive Potential und das negative Potential - oder der Schutzleiter PE - werden in den Anschlußebenen B und C (und ggf. auch in den Anschlußebenen D, E und F) jeweils vom Anschluß B1 zum Anschluß B2 usw. durchkontaktiert. Damit ist es auf einfache Weise möglich, die Potentiale zu den Anschlüssen B1 und B2 usw. jeweils nur über eine einzige Stromschiene SM oder SP zuzuführen, was - wie in Fig. 2 zu erkennen - nach der Idee der Erfindung derart erfolgt, daß die Stromschienen SP, SM, SPE für jedes Potential nur auf einer der beiden Seiten links und rechts der Hauptebene HE liegen. Werden in der zweiten Ebene B z.B. das Minus und in der dritten Anschlußebene das Pluspotential benötigt, ist es somit möglich, diese beiden Potentiale auf den voneinander abgewandten Seiten der Modulscheiben MS zu den Anschlußebenen zu führen. Diese Stromschienenführung ist außerordentlich platz- und materialsparend, da aufwendige Doppelführungen von Stromschienen zu den einzelnen Anschlußebenen vermieden werden. Darüberhinaus ermöglicht die Potentialführung auf beiden Seiten der Modulscheiben MS durch die vorstehend beschriebenen Vorteile auch die platzsparende Verlängerung der Stromschienen zu weiteren Anschlußebenen, insbesondere zu den Anschlußebenen E und F (siehe hierzu auch die Ausführungen zu Fig. 5 und 7). Die Potentialführung PE des Schutzleiters ist vorzugsweise direkt, insbesondere einstückig mit der Anschlußebenen drei (C) oder vier (D) verbunden.

Neben der reinen Spannungsversorgungs- und Erdungsfunktion ermöglicht das erfindungsgemäße elektrische Gerät G auch die Übertragung von Daten. Zu diesem Zweck erfolgt mittels eines internen Busleiters BUS, 10 eine Datenübertragung zwischen dem Gateway GW und den Modulscheiben MS bzw. den Modulblöcken MB. Über die in Fig. 3a dargestellte Elektronikleiterplatte 14 erfolgt die Kommunikation zwischen dem internen Busleiter BUS und den externen elektrischen Geräten, deren Datenein-/-ausgänge über die Anschlußebene mit der Kennzeichnung "S" (in der ersten Anschlußebene A und/oder in der vierten Anschlußebene D) zur Elektronikleiterplatte 14 geführt werden.

Fig. 3a zeigt im Zusammenspiel mit den Fig. 3b bis 3h verschiedene Ansichten sowie verschiedene Elemente einer Modulscheibe. MS, welche mit weiteren Modulscheiben MS und/oder Modulblöcken MB zu einem Anschlußblock variabler Länge zusammenfügbar ist (Fig. 1 und 2).

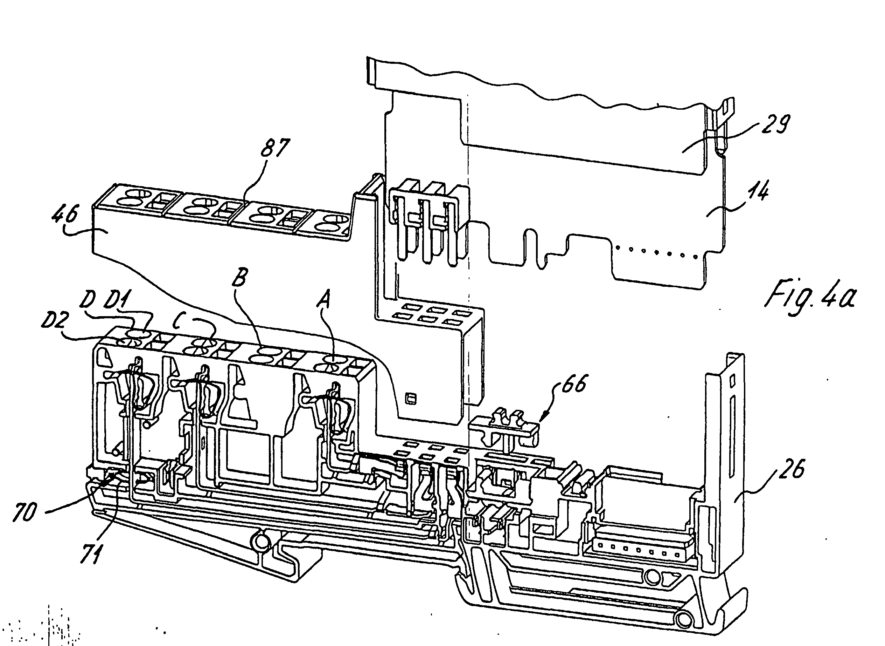

Die Modulscheibe MS weist nach Fig. 3a und 4a einen scheibenförmigen Basis-Klemmenträger 2 zur Verriegelung des Einzelmodules auf einer (hier nicht dargestellten) Tragschiene auf. Der Basis-Klemmenträger 2 ist hierzu mit Kunststoff-Rastfüßen 4 versehen, mit denen in an sich bekannter Weise die Rastverbindung zur Tragschiene herstellbar ist. Der Basis-Klemmenträger 2 umfaßt einen unteren Basisabschnitt 6, welcher sich in einen Bereich oberhalb der Tragschienenfüße 4 und neben den Tragschienenfüßen 4 beidseits seitlich über die Tragschiene hinaus erstreckt. In dem Basisabschnitt 6 ist in dem einen von der Tragschiene abgewandt liegenden Außenbereich eine den Basis-Klemmenträger 2 senkrecht zu seiner Haupt-Erstreckungsebene durchdringende Busleiteröffnung 8 zur Aufnahme des internen Busleiterabschnitts 10 vorgesehen, der eine Weiterleitung der Busleitersignale von Einzelmodul zu Einzelmodul und in die Elektronikleiterplatte 14 erlaubt.

Zur Aufnahme der Elektronik-Leiterplatte 14 ist in dem Bereich, welcher sich ungefähr von der Senkrechten zur Mitte der Tragschiene bis zu dem internen Busleiterabschnitt 10 erstreckt, in dem Basis-Klemmenträger 2 eine Umfangs-Ausnehmung 12 ausgebildet. Die Elektronikleiterplatte 14 ist mit einer (hier nicht dargestellten) Elektronikschaltung zur Verarbeitung/Weiterleitung der jeweils zur Elektronikleiterplatte 14 geführten Signale versehen.

In dem zwischen dem internen Busleiterabschnitt 10 und dem Rastfuß 4 liegenden Bereich ist der Basisabschnitt 6 mit drei weiteren, nebeneinander liegenden Öffnungen 16, 17, 18 versehen, die jeweils senkrecht zur Hauptscheiben- bzw. modulebene den Basis-Klemmenträger 2 durchdringen und von denen zwei Öffnungen 16, 18 mit als vorzugsweise einstückigen Querbrückern ausgelegten Kontaktelementen 20, 22 (auf der einen Seite mit einem Steckerstift 20a, 22a, auf der anderen mit dazu passender, einstückig angeformter Buchse 20b, 22b sowie daran angeformten Kontaktaufnahmen 20c, 22c senkrecht nach oben) versehen sind, welche eine Weitergabe der zugeordneten Potentiale - vorzugsweise des Plus- oder Minus- Versorgungspotentiales - von Modul zu Modul ermöglichen. In ihrem Zusammenspiel bilden die Kontaktelemente 20, 22 die Potentialführungen PF+ und PF-. Die weitere Öffnung 17 dient - wie weitere der hier nicht beschriebenen Öffnungen im Basis-Klemmenträger - lediglich der Materialersparnis. Von den Querbrückem 20, 22 werden diese Potentiale in die Leiterplatte und/oder über einen geeigneten separaten oder an die Elektronikleiterplatte angesetzten Stecker 24 zu den Anschlüssen der Stromschienen SM, SP im Basis-Klemmenträger 2 und über diese zu den Anschlußebenen der Modulscheibe MS geführt.

Die Ausnehmung 12 wird an dem von der Tragschiene abgewandten Ende des Einzelmodules von einem senkrecht vom Basisabschnitt abstehenden Steg 26 begrenzt, der an seiner zur Tragschiene 4 gewandten Seite mit einer Einschubnut 28 zum Einschieben der Elektronik-Leiterplatte 14 sowie eines Elektronikgehäuses 29 versehen ist.

Ungefähr an dem dem Steg 26 gegenüberliegenden Ende des Basis-Klemmenträgers 2 ist an den Basisabschnitt 6 ein senkrecht nach oben vorstehender Anschlußabschnitt 30 angeformt, der mit den sechs in zwei Reihen zu je drei angeordneten Einzel- (A1, A2) und Doppel-Anschlüssen B1, B2, C1, C2 versehen ist. Öffnungen 34 mit quadratischem Querschnitt neben Anschlußöffnungen 32 für die Anschlüsse A1, A2, B1, B2 ... erlauben das Einführen eines Schraubendrehers zum Öffnen der im Anschlußabschnitt 30 angeordneten Feder-Kontaktelemente 36.

Außerhalb der dritten Anschlußebene C ist im Basisabschnitt eine weitere senkrecht zur Modulscheibenebene liegende, den Basis-Klemmenträger 2 durchdringende Öffnung 38 vorgesehen, in welcher ein weiteres Kontaktelement 40 liegt, über das der Schutzleiter PE von Einzelmodul zu Einzelmodul weitergegeben wird. Vom Kontaktelement 40 ist ferner über Stromschienen SPE (siehe Fig. 5f) eine Verbindung zu einer der Anschlußebenen (z.B. C oder D) herstellbar. In Fig. 5f werden die Kontaktelemente bzw. Querbrücker 40 einstückig mit der Stromschiene SPE zur dritten Anschlußebene C, D ausgeführt.

Die leitende Verbindung zwischen den Kontaktfedern 36 der Anschlüsse A, B, C, ... und der Elektronikleiterplatte 14 wird mittels der Stromschienen SM (für das Minuspotential), SP (für das Pluspotential), SSI (für das Signal) realisiert, die jeweils zunächst von den Kontaktfedern 36 im Anschlußbereich 30 des Basis-Klemmenträgers 2 senkrecht nach unten bis in den Basisabschnitt 6 verlaufen und dann im Basisabschnitt 6 zur Elektronikleiterplatte 14 geführt werden. Die Stromschienen SM, SP verlaufen von den Kontaktfedern 36 in seitlichen Nuten/Ausnehmungen 42 des Grundelementes 2 im wesentlichen u-förmig an beiden Hauptaußenflächen (also im Bezug auf die Darstellung der Fig 3b-d auf der vordeten und der hinteren Seite) des Basis-Klemmenträgers 2. Unterhalb der Aussparung 12 für die Elektronik-Leiterplatte sind die Stromschienen nach oben hin abgewinkelt und verlaufen zur Umfangs-Ausnehmung 12, welche in diesem Bereich mit sechs in zwei Reihen nebeneinander liegenden Anschlußöffnungen 44 zum Aufsetzen des Gerätesteckers 24 an der Elektronikleiterplatte und/oder des Leiterplattenrandes versehen ist. Die Endbereiche der Stromschienen SSI, SM, SP sind als Stanz-Biegeteilbuchsen ausgeführt und bilden selbst die Anschlußbuchsen für den Gerätestecker 24 zur Elektronikleiterplatte 14 und/oder zum Leiterplattenrand.

Eine besonders raumsparende Anordnung der Stromschienen wird dadurch erreicht, daß die eine der potentialtragenden Stromschienen SM auf der einen Außenseite (siehe Fig. 3d) und die andere potentialtragende Stromschiene SP auf der anderen Außenseite (siehe Fig. 3b) des Basis-Klemmenträgers 2 geführt ist. Erst im Bereich der Anschlußfedern 36 erfolgt die Durchkontaktierung zwischen den beiden in einer Anschlußebene B oder C nebeneinander liegenden zwei Doppelanschlüssen B1 und B2 usw..

Über den Anschlußabschnitt 30 ist ein Abdeckgehäuse 46 aus Kunststoff aufsetzbar, welches Öffnungen 48 aufweist, die mit den Anschlußöffnungen 32 und den Öffnungen 34 korrespondieren. Zum Bereich der Aussparung 12 des Basis-Klemmenträgers 2 hin ist die Abdeckung ferner mit einer seitlichen Nut 50 versehen, welche im Zusammenwirken mit der Nut 28 die Elektronikleiterplatte 14 und das die Elektronikiciterplatte 14 schützende Gehäuse 29 aufnimmt, welches in Steckrichtung SR auf den Basis-Klemmenträger 2 aufsetzbar ist. Führungszapfen F am Basis-Klemmenträger unterstützen beim Eingriff in eine zugehörige Öffnung der Nachbarklemme die mechanische Verbindung der aneinandergereihten Klemmenträger.

Der Basis-Klemmenträger 2 bzw. die Modulscheibe MS umfaßt im Bereich der Aussparung 12 an/unterhalb der Grundwandung 52 der Aussparung 12 (von dem Steg 26 aus gesehen nach innen zur Tragschiene hin) folgende Funktionsbereiche (siehe auch Fig. 3c) :
- Modulbus(öffnung) BUS / 8
- Kennzeichnungskanal (für ein oder zwei Schilder) 54
- seitlicher Rasthaken 56 als Verbindung zur Nachbarklemme mit Öffnung 57 zur Betätigung des Rasthakens von oben 56, 57
- FE-Kontakt (Funktionserde) 58
- Potentialführungs-Kontaktierungsöffnung 59
- Steckerbuchsen/Anschlußöffnungen 44 mit folgender Belegung:
   - zweimal Signal-Stromschienen SSI der vierten Ebene D (44a,b);
   - Plus-Minus-Stromschienen zu den Doppelanschlüssen B1, B2 usw. (44c,d);
   - zweimal Signal-Stromschiene SSI aus der ersten Anschlußebene A (44e,f).

Neben dem FE-Kontakt 58 und den Öffnungen 44 zu den Potentialführungen PE+, PEist in besonders raumsparender Weise eine Ausnehmung 62 für einen unteren Abschnitt 64 eines Kodierelementes 66 (Fig. 3a) vorgesehen, welches beim Aufsetzen der Leiterplatte bzw. der Elektronik vom Gehäuse 29 der Elektronikleiterplatte 14 in die Ausnehmung 62 einrastet und damit das Gegenstück für ein an der Elektronikeinheit 12/29 verbleibendes oberes Kodierelement 68 bildet.

Bezüglich der raumsparenden Anordnung der Funktionsbereiche der Modulscheibe im Bereich der Aussparung 12 ist noch hervorzuheben, daß die Leiterplatte 14 derart im Gehäuse 29 bzw. in der Ausnehmung 12 seitlich versetzt parallel zur Hauptebene HE angeordnet wird, daß an ihren Leiterplattenrand Steckerstifte anformbar oder Steckerbuchsen ansetzbar sind. Dazu gehören Steckerelemente des internen Busleiters (hier nicht dargestellt) sowie eine der zwei Reihen der Steckerstifte des Gerätesteckers 24 zum Eingriff in die Kontaktöffnungen 44. Auf diese Weise - also durch die Kontaktierung am Leiterplattenrand - werden separate Gerätestecker eingespart, die ansonsten die jeweilige Kontaktierung übernehmen müßten. Auch die Kontaktierung der Potentialführungen durch die Potentialführungs-Kontaktierungsöffnung 59 erfolgt durch direkt an die Leiterplatte 14 angeformte Steckerstifte (hier nicht zu erkennen).

Ein weiterer Vorteil der erfindungsgemäßen Modulscheibe MS liegt darin, daß der seitliche Rasthaken 56 bequem vor der Öffnung 57 im Bereich 57' oder von oben durch die Öffnung 57 mit einem Schraubendreher heruntergedrückt und damit die Verriegelung zur benachbarten Modulscheibe (Öffnung 61) auf einfachste und übersichtliche Weise gelöst werden kann.

Dadurch, daß das Plus- und das Minuspotential in die zwei nebeneinander bzw. beidseits der Hauptebene liegenden Öffnungen 44c, 44d geführt wird, also dadurch, daß von den parallel zur Tragschiene verlaufenden Potential führungen PF+ und PFeine Weiterleitung dieser beiden Potentiale zu den beidseits der Hauptebene HE nebeneinanderliegenden Anschlüssen 44c, 44d erfolgt, wird die Stromschienenführung der einzelnen Potentiale jeweils nur auf einer der beiden Außenseiten der Modulscheibe MS deutlich vereinfacht. Dadurch, daß die der Anschlußebene A am nächsten liegenden Anschlüsse 44e und f zur Signalzuleitung zur Elektronikleiterplatte genützt werden, brauchen zudem nur sehr kurze Stromschienen SSI zwischen den Öffnungen 44e, f und der Anschlußebene A eingesetzt zu werden.

Zusammenfassend wird durch die Anordnung der Funktionsbereiche im Bereich der Elektronik-Leiterplatte eine besonders raumsparende Modulscheiben- und Basis-Klemmenträgeraufteilung realisiert.

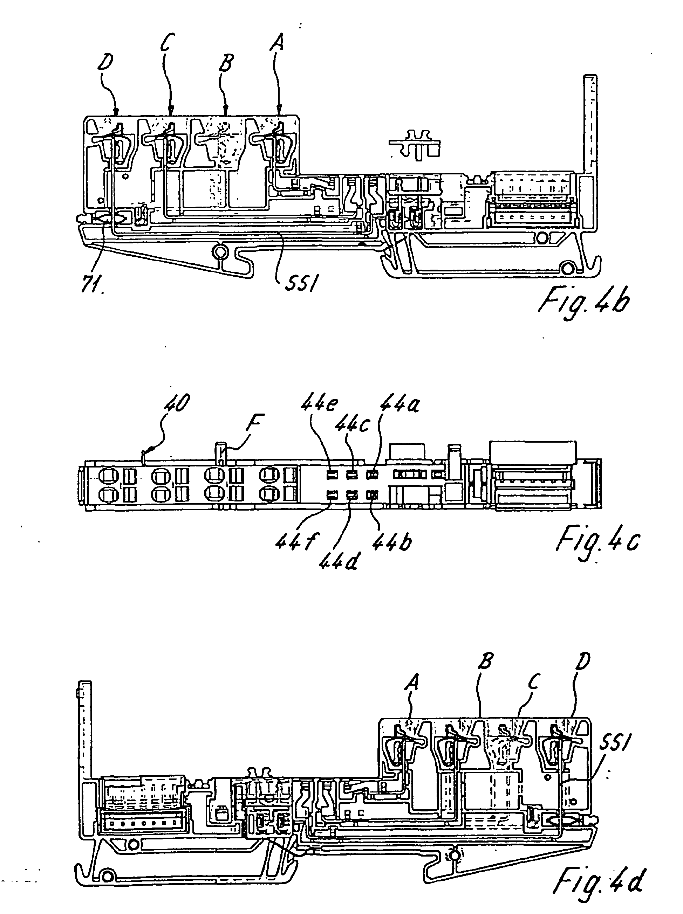

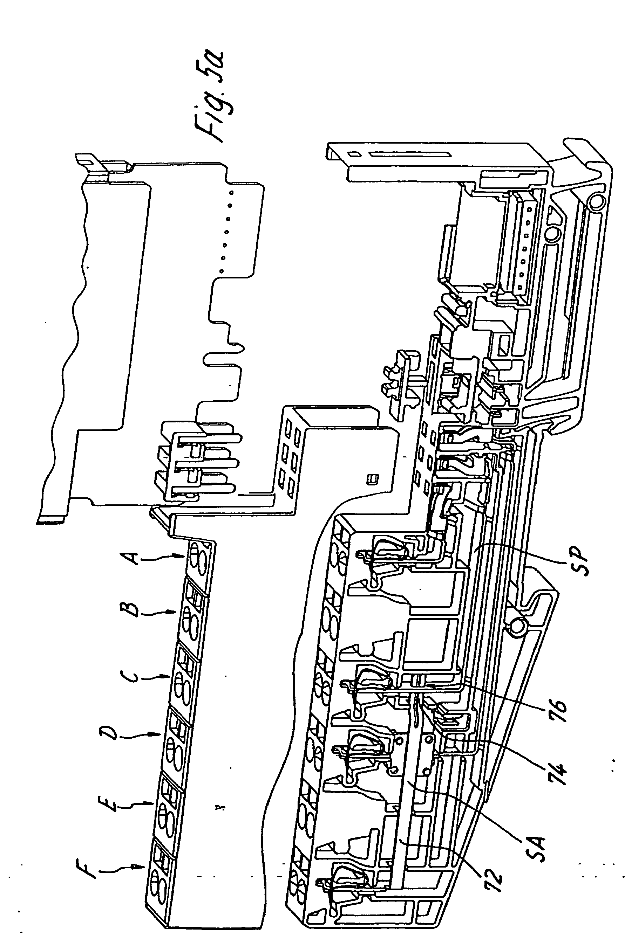

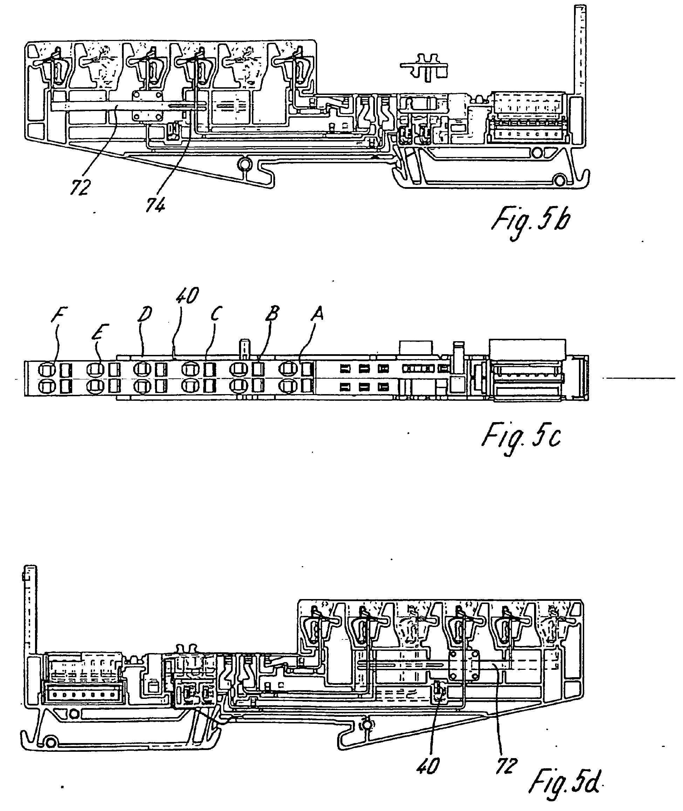

Das Ausführungsbeispiel der Fig. 4 unterscheidet sich von dem der Fig. 3 insbesondere dadurch, daß die Modulscheibe nicht nur drei sondern insgesamt vier Anschlußebenen A, B, C, D aufweist.

Durch die geschickte raumsparende Anordnung des Schutzleiters PE (Kontakte 40) zwischen der dritten und vierten Anschlußebene C, D im unteren Bereich des Basis-Klemmenträgers 2 ist es möglich, den Schutzleiter 40 mit nur sehr kurzen Stromschienenstücken SPE (siehe Fig. 5f) entweder zur Anschlußebene C oder D zu führen, wobei das positive Potential im letzteren Fall zur Anschlußebene C legbar ist. Von der Tragschiene aus betrachtet ist außerhalb der Öffnung 38 für den Schutzleiterkontakt 40 noch eine weitere Querverbindungsöffnung 70 vorgesehen, bestückbar mit Querbrückem 71, von der Stromschienen zur Anschlußebene D legbar sind, wodurch die Einzelkontakte der Anschlußebene D ohne größeren Aufwand brückbar sind (z.B. zur Verdrahtung eines gemeinsamen Relaiswurzelpotentials innerhalb der Modulscheibe MS oder eines Modulblockes MB und über mehrere Modulscheiben MS oder Modulblöcke MB hinweg).

Die Version der Fig. 5 unterscheidet sind von der der Fig. 4 durch weitere Anschlußebenen E und F, wobei zwei mögliche Stromschienenführungen dieses Ausführungsbeispieles in Fig. 5e und 5f dargestellt sind. Bei dem Ausführungsbeispiel der Fig. 5e sind die erste und die vierte Anschlußebene als Signalanschluß-Ebenen ausgelegt, die zu den Öffnungen 44a, 44b und 44e, 44f geführt werden. Die zweite und dritte bzw. die fünfte und sechste Anschlußebene B,C und E, F sind mit dem Minus-und dem Pluspotential belegt. Fig. 5e zeigt ferner die FE_Stromschiene und die Ausbildung der Endbereiche der Stromschienen (SFE, SSI, SM, SP, SPE) als Stanz-/Biegeteil-Kontaktaufnahmen 45 zum Anschluß weiterer Stromschienen oder Leiterplattenränder.

Das Ausführungsbeispiel der Fig. 5f unterscheidet sich von dieser Version lediglich dadurch, daß in Fig. 5f in der dritten und sechsten Ebene, also in den Ebenen C und F anstelle des positiven Potentiales die Schutzerde liegt. Die Potentialzuführung zu den Anschlußebenen E und F erfolgt unkompliziert jeweils durch eine Verlängerungs-Stromschiene 72, von denen eine ca. in der Mitte der Modulscheibe und die andere auf einer der Außenseiten der Modulscheibe 90° verdreht zu den jeweils zu verlängernden Stromschienen geführt ist. Die Verlängerungs Stromschienen 72 der Fig. 5e und 5f sind an einem ihrer Enden geschlitzt ausgeführt, wobei der geschlitzte Abschnitt 74 in Öffnungen 76 der jeweiligen Stromschienen SM oder SP oder SPE eingreift. Mit Hilfe dieser Technik ist bei entsprechender geschickter Verlegung der Stromschienen am Klemmenkörper sogar eine nochmalige Verlängerung der Stromschienen bzw. eine Weiterleitung zu hier nicht dargestellten weiteren Anschlußebenen des Anschlußmodules M denkbar.

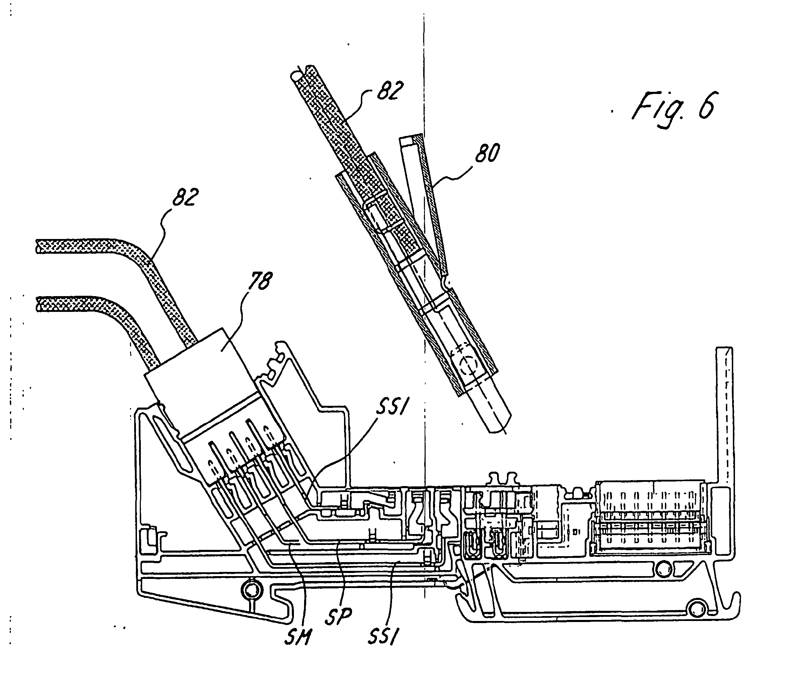

Das Ausführungsbeispiel der Fig. 6 unterscheidet sich von den Ausführungen der Fig. 3 bis 5 durch die verwendete Anschlußtechnik. Anstelle der Anschlußebenen mit Schraub- oder Federtechnik erfolgt der Anschluß der externen Geräte mittels platzsparender Sensor-/Aktorstecker 78, die jeweils mit einer Klemm- und/oder Schneidvorrichtung 80 zum Festklemmen und ggf. zum Durchdringen der Isolierungen von in den Stecker 78 eingesetzten Leitern 82 (Schneid-/Klemmtechnik, Crimp) versehen ist.

In Fig. 7 wird das Anschlußmodul als Modulblock MB mit sechs Anschlußebenen A bis F realisiert. Der Modulblock MB weist zwar noch einen scheibenförmigen Aufbau auf, es wird jedoch nur eine einzige übergreifende Elektronikleiterplatte (hier nicht dargestellt) sowie ein einziges übergreifendes Elektronikgehäuse 29 (nicht dargestellt) und ein einziges, mehrere Basis-Klemmenkörper 2 gemeinsam übergreifendes Abdeckgehäuse 46' (nur beispielhaft mit vier Anschlußebenen dargestellt) für die Anschlüsse der Anschlußebenen A, B ,.. verwendet. Darüberhinaus werden die Potentiale PE, + und - nur in einer oder beider der relativ zur Tragschiene stirnseitigen Scheiben 2 mittels Stromschienen SM, SP, SPE von den Potentialführungen PE, PF+ und PF- zu den Anschlußebenen B bis F geleitet. Von Scheibe zu Scheibe erfolgt die Weiterleitung dieser Potentiale über Querverbinderkämme 84, die mit Zapfen 85 versehen sind, welche in an die Stromschienen SM, SP oder SPE angeformte Aufnahmebuchsen 86 eingreifen. Die Querverbinderkämme 84 sind jeweils mit den Klemmfederanschlüssen 36 versehbar und werden auf das Abdeckgehäuse 46' aufgesetzt, durch welches sie beim Aufsetzen des Abdeckgehäuses 46' in die Basis-Klemmenträger 2 eintauchen. Mittels eines Deckels 89 werden das Abdeckgehäuse 46' und die Querverbinderkämme nach oben hin abgedeckt. die Stromschienen der Potentialführungen (PF-,PF+ und/oder PE) der Modulblöcke (MB) aus verschieden langen Stromschienenabschnitten bestehen.

Die Verlängerungsstromschienen 72' des Modulblockes (MB) sind jeweils um 90° verdreht ausgerichtet und an ihren Enden senkrecht nach oben mit Aufnahmebuchsen 86' zur Kontaktierung der Zapfen 85 der Querverbinderkämme 84 versehen. Die um 90° verdrehten Verlängerungsstromschienen 72 werden vorzugsweise von gesondert einlegbaren und/oder am Basis-Klemmenträgern angespritzten Isolierscheiben von dem Potential der Stromschiene der Anschlußebene D (luft- und kriechstreckenseitig) getrennt (hier nicht zu erkennen).

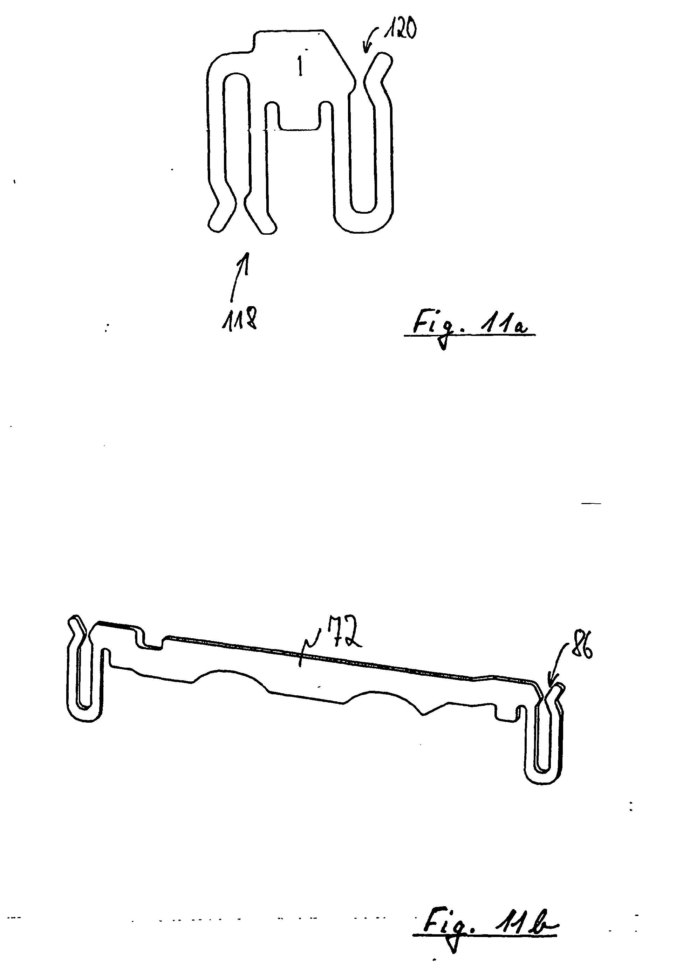

Eine Version eines PE-Querbrückers 118 (siehe Fig. 11) ist bei den Modulblöcken MB senkrecht zu den seitlichen Ausnehmungen 42 der Basis-Klemmenträger 2 angeordnet und weist an seinen Enden mindestens eine Aufnahmebuchse (nach oben) 120 zur Kontaktierung der Querverbinderkämme 84 und eine Aufnahmebuchse (nach unten) zur Kontaktierung der Stromschiene SPE auf. Fig. 1c und 1d sowie Fig. 7b verdeutlichen zusätzlich, daß die Stromschienen der Potentialführungen PF-,PF+ und/oder PE) der Modulblöcke MB aus einer einzigen übergreifenden oder aus mehreren gleich langen oder verschieden langen Stromschienenabschnitten bestehen können (siehe zum Beispiel in Fig. 1c MB1 und MB3 in Hinsicht auf die PF+-Führung). Es ist auch denkbar, bei den Modulblöcken MB die Potentialführungen PF-,PF+ und/oder PE aus den Querbrückem 20, 22 des Scheibenaufbaus zusammenzusetzen. Denkbar ist es schließlich, für den Blockaufbau entweder einen den gesamten Block übergreifenden Basis-Klemmenträger 2 einzusetzen (hier nicht dargestellt) oder wiederum die scheibenartigen Basis-Klemmenträger 2 - z.B. nach Art der Fig. 3 - zu verwenden. Bei der letztgenannten Variante könnten mehrere der Basis-Klemmenträger sowie ggf. auch mehrere der Anschluß- und/oder Elektronikhauben 46, 29 für den Scheibenaufbau nach Art einer vormontierten Einheit vor dem Aufrasten auf eine Tragschiene zu einem übergreifenden Block zusammengestellt werden (z:B. mittels einer Stange oder mittels Schwalbenschwanzverbindungen, z.B. zwischen den Abdeckgehäusen 46 oder den Basis-Klemmenträgern 2 (hier wiederum nicht dargestellt)).

Auf diese Weise läßt sich gegenüber einem Aufbau aus vollständig voneinander trennbaren Modulscheiben MS durch den Modulblock MB eine erhebliche Material - und damit Kostenersparnis erzielen, die den Blockaufbau insbesondere dann wirtschaftlich macht, wenn eine größere Anzahl einheitlicher Geräte zu steuern oder zu überwachen ist. Der Modulblock MB ist wiederum mit weiteren Modulblocks MB - aber auch mit einzelnen Modulscheiben MS - beliebig zusammenreihbar. Das System ermöglicht damit sowohl die Realisierung als reiner Scheibenaufbau als auch eine reine Blocklösung oder eine Mischung dieser beiden Formen. Über eine hier nicht dargestellte Abschlußplatte wird das System vervollständigt.

Zwischen den Anschlußebenen sind die Abdeckgehäuse 46 der Modulblöcke mit Nuten 87 zur übersichtlichen Zuordnung von Schraubendreher-Führung, Leitereinführung, farbiger Potentialmarkierung und Beschriftung eines Anschlusses bzw. zur Abgrenzung anderer Anschlußebenen und zur Aufnahme farbiger Potentialmarkierungen versehen.

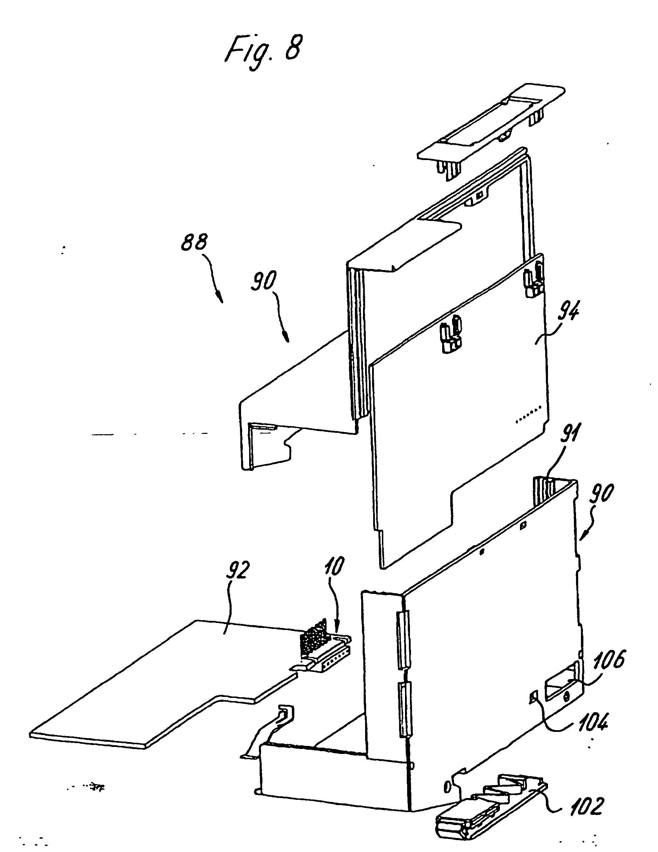

Fig. 8 zeigt eine Abbildung eines Gatewaygehäuses 88 dessen Wandungen 90 der Ausgestaltung der Modulscheiben MS angepaßt isf. Das Gehäuse ist mit einer Aufnahme für einen FE-Kontakt sowie mit Leiterplattenführungen 91 für eine waagerecht ausgerichtete Anschlußleiterplatte 92 und eine senkrecht dazu ausgerichtete Elektronik-Leiterplatte 94 versehen, welche auf die Anschluß-Leiterplatte 92 aufsteckbar ist. Eine Aufnahme ist für einen insbesondere selbstfedernden Fuß 102 vorgesehen. Gehäusedurchbrüche 104 und 106 sind zu Kontaktierung des internen Busleiterabschnitts und des Rasthakens der ersten an das Gateway angereihten Modulscheibe MS vorgesehen.

Besondere Vorteile dieses Gehäuses liegen in seinem einfachen Aufbau sowie in der kompletten Umfassung der Leiterplatten durch das im wesentlichen nur zweiteilige Gehäuse 88. Störungen auf dem Feldbuskabel sind direkt über den FE-Kontakt auf der Anschluß-Leiterplatte zur Tragschiene ableitbar. Das Gateway GW ermöglicht den Anschluß eines externen Feldbusses. An das Gateway schließt jeweils die ebenfalls als Modulscheibe MS ausgelegte Einspeisescheibe an. Besonders vorteilhaft ist, daß die Strom- und Spannungsversorgung des Gateways GW und der Anschlußmodule M über die an das Gateway GW angereihte Einspeisescheibe MS (vorzugsweise über den internen Busleiterabschnitt) erfolgt.

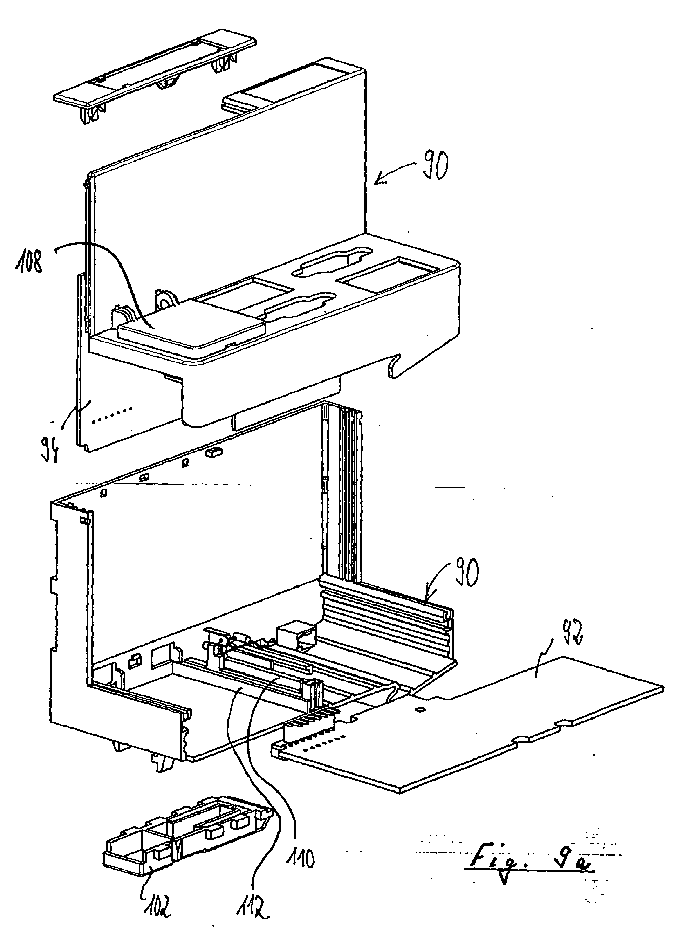

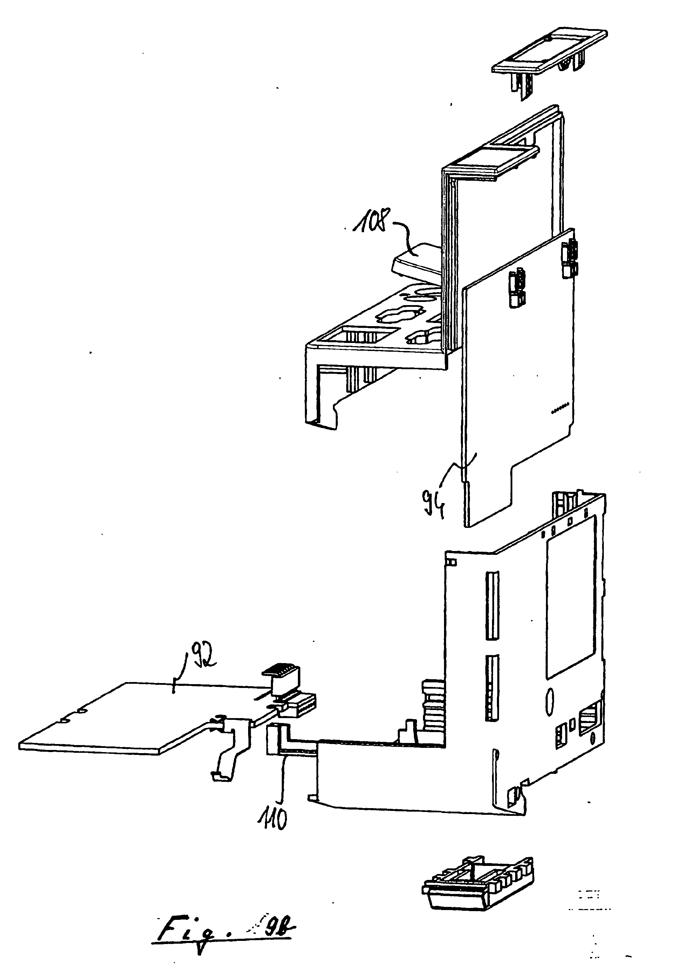

Fig. 9a und Fig. 9b zeigen eine Variante des Gateways aus Fig. 8. Eine Schutzklappe 108 deckt in vorteilhafter Weise einen (in Fig. 9 ansonsten nicht dargestellten) Steckanschluß, beispielsweise für einen Service-Stecker und/oder einen Hex-Drehkodierschalter ab.

Zur Stabilisierung und Abstützung der Wandungen 90 des Gehäuses 88 dient eine Art Stützstab 110, der in eine Profilnut 112 der unteren, hier waagerecht liegenden Wandung 90 einschiebbar ist.

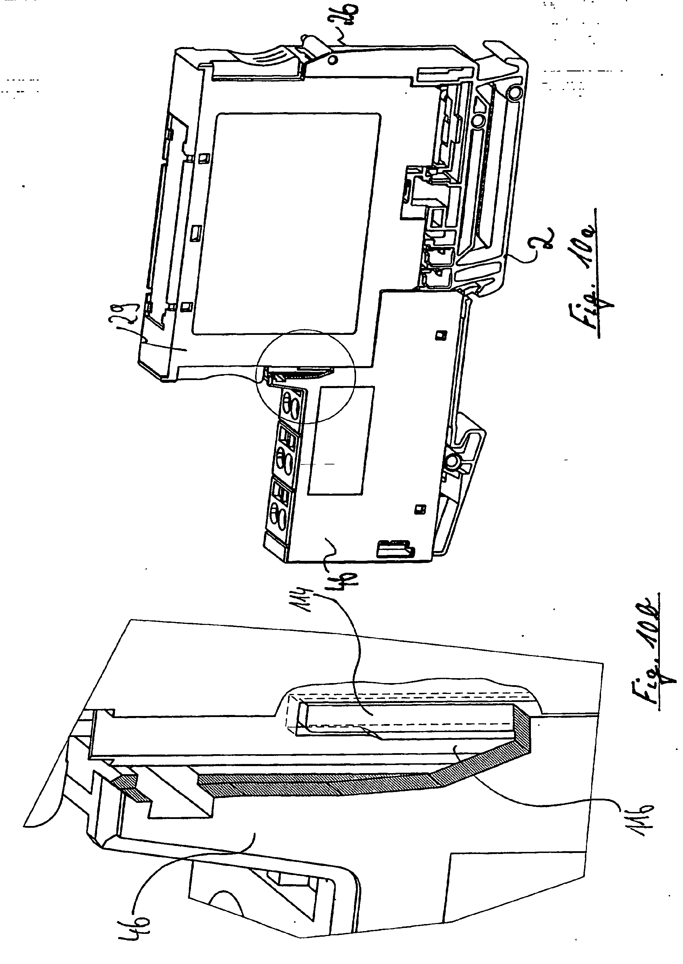

Fig. 10 veranschaulicht den zusammengebauten Zustand eines Basis-Klemmenträgers 2 nebst den darauf aufgesetzten Elementen Abdeckgehäuse 46 und Elektronikgehäuse 29. Die dem Steg 26 gegenüberliegende Seite des Abdeckgehäuses 46 und das Elektronikgehäuse 29 sind aneinander durch zwei ineinandergreifende Rastelemente 114, 116 geführt. Eine Verriegelung ist ebenfalls denkbar.

Fig. 11a zeigt schließlich den weiteren PE-Querbrücker 118 und Fig. 11b eine weitere Variante einer Verlängerungsstromschiene 72 für den Blockaufaufbau. Der Vorteil dieser Varianten ist, daß die Elemente einfach als Stanzteile aus einem Blechstreifen herausgestanzt werden, wobei die Aufnahmebuchsen 86 bzw. 120 in der Ebene der übrigen Verlängerungsstromschiene 72 bzw. des übrigen Querbrückers 118 liegen.

### Bezugszeichen

### Zum Grundprinzip:

- Gerät: G
- Gateway: GW
- Anschlußelemente: SB
- Anschlüsse/Diagnoseschittstellen: AB
- Schalter: SC
- Anschlußmodule: M
- Modulscheibe: MS
- Modulblock: MB
- Anschlußebenen: A, B, C, ...
- Mehrfachanschlüsse: A1, A2, ... B1, B2, ...
- Signal: S
- Minus: -
- Plus: +
- Schutzerde: PE
- Funktionserde: FE
- Stromzuführschienen: SM, SP, SSI, SPE, SFE
- Hauptebene: HE
- Steckrichtung: SR
- interner Busleiter: BUS
- Führungszapfen: F

### Zur Modulscheibe:

- Basis-Klemmenträger: 2
- Kunststoff-Rastfüße: 4
- Basisabschnitt: 6
- Busleiteröffnung: 8
- Int. Busleiterabschnitt: 10
- Umfangs-Ausnehmung: 12
- Elektronik-Leiterplatte: 14
- Öffnungen: 16, 17, 18
- Kontaktelemente: 20, 22
- Stecker: 24
- Steg: 26
- Einschubnut: 28
- Elektronikgehäuse (E/A-Modulgehäuse): 29
- Anschlußabschnitt: 30
- Öffnungen: 32
- Öffnungen: 34
- Feder-Kontaktelemente: 36
- Öffnung: 38
- Kontaktelement: 40
- Aussparungen: 42
- Anschlußöffnungen: 44
- Kontaktaufnahme: 45
- Abdeckgehäuse: 46
- Öffnungen: 48
- Nut: 50
- Grundwandung: 52
- Kennzeichnungskanal: 54
- Seitlicher Rasthaken: 56
- Öffnung: 57
- FE-Kontakt: 58
- Potential-Kontaktierungsöffnung: 59
- Öffnung: 61
- Ausnehmung: 62
- unterer Kodierlelementabschnitt: 64
- Kodierelement: 66
- oberer Kodierlelementabschnitt: 68
- Querverbindungsöffnung: 70
- Verlängerungs-Stromschiene: 72
- PE-Querbrücker: 73
- geschlitzter Abschnitt: 74
- Öffnungen: 76
- Stecker: 78
- Klemmvorrichtung: 80
- Leitern: 82
- Querverbinderkämme: 84
- Zapfen: 85
- Aufnahmebuchsen: 86
- Aufnahmenuten: 87
- Gatewaygehäuse: 88
- Deckel: 89
- Wandungen: 90
- Leiterplattenführungen: 91
- Anschlußleiterplatte: 92
- Elektronik-Leiterplatte: 94
- Fuß: 102
- Gehäusedurchbrüche: 104,106
- Schutzklappe: 108
- Stützstab: 110
- Profilnut: 112
- Rastelemente: 114, 116
- Querbrücker: 118
- Aufnahmebuchsen: 120

## Patentansprüche

1. Elektrisches Gerät mit modularem Aufbau zur Steuerung und/oder Überwachung technischer Prozesse und/oder zur Industrie- und/oder Gebäudeautomatisierung, mit
wenigstens einem auf eine Tragschiene aufsetzbaren Anschlußmodul, (M) das mit mehreren Ebenen (A, B, C, D, ...) von Anschlüssen (A1, A2, B1, ...) zum Anschluß externer Leiter versehen ist und eine Aneinanderreihung aus scheibenförmigen Basis-Klemmenträgern (2) aufweist,
wobei innerhalb jedes Anschlußmodules (M) im wesentlichen parallel zur Tragschiene ein interner Busleiter (BUS) sowie mehrere Potentialführungen (PE; PF+, PF-) verlaufen, wobei die Potentialführungen vorzugsweise über Stromschienen der scheibenförmigen Basis-Klemmenträger (2) und ggf. über weitere Elemente mit den Anschlußebenen verbunden sind,
**dadurch gekennzeichnet, daß**
die Stromschienen (SM, SP, SPE) zur Potentialzuführung zu den Anschlußebenen (B, C, D, ...) auf die beiden Seiten des Basis-Klemmenträgers (2) verteilt sind und die Stromschienen jedes einzelnen Potentiales (SM, SP, SPE) nur jeweils auf einer der Seiten des Basis-Klemmenträgers (2) zu den zugehörigen Anschlüssen (B1, B2, ...) geführt sind,
wobei die mit einem gemeinsamen Potential zu versorgenden Anschlüsse (B1, B2, ...) direkt miteinander zu Mehrfachanschlüssen verbunden sind.

2. Elektrisches Gerät nach Anspruch 1, **dadurch gekennzeichnet, daß**
- jedes Anschlußmodul aus beliebig aneinanderreihbaren und miteinander kombinierbaren Modulscheiben (MS) und/oder Modulblöcken (MB) besteht, die jeweils auf den aneinanderreihbaren Basis-Klemmenträgern (2) aufbauen, die scheiben- oder blockartig ausgelegt sind,
- wobei die Modulscheiben (MS) und die Modulblöcke (MB) jeweils mindestens eine Elektronikleiterplatte (14), ein Elektronikgehäuse (29) und ein Abdeckgehäuse (46) aufweisen.

3. Elektrisches Gerät nach Anspruch 2, **dadurch gekennzeichnet, daß** die Elektronikleiterplatte (14), das Elektronikgehäuse (29') und das Abdeckgehäuse (46') der Modulblöcke (MB) jeweils mehrere und das Abdeckgehäuse (46) sowie vorzugsweise die Elektronikleiterplatte und das Elektronikgehäuse (29) der Modulscheiben (MS) jeweils vorzugsweise nur einen der Basis-Klemmenträger (2) übergreifen.

4. Elektrisches Gerät nach Anspruch 2, **dadurch gekennzeichnet, daß** jeweils eine der Elektronikleiterplatten (14) und eines der Elektronikgehäuse (29) mehrere der aneinandergereihten Modulscheiben (MS) übergreifen und/oder daß ein Modulblock mit mehreren Elektronikgehäusen (29) und/oder Elektronikleiterplatten (14) versehen ist.

5. Elektrisches Gerät nach einem der vorstehenden Ansprüche, **dadurch gekennzeichnet, daß** die Potentialführungen (PE, PF+, PF-) aus Querbrückern (20, 22, 40) in Durchtrittsöffnungen (16, 18, 38) vorzugsweise im zur Tragschiene gewandten unteren Bereich der Basis-Klemmenträger (2) zusammengesteckt sind.

6. Elektrisches Gerät nach einem der vorstehenden Ansprüche, **dadurch gekennzeichnet, daß**
- zwei der Potentialführungen (PF-, PF+) zur Weiterleitung eines positiven und eines negativen Potentiales unterhalb einer Umfangs-Ausnehmung (12) zur Aufnahme der Elektronik-Leiterplatte (14) und des Elektronikgehäuses (29, 29') angeordnet sind, und daß
- eine weitere der Potentialführungen (PE) zur Weiterleitung des Schutzleiterpotentiales zwischen der dritten und der vierten Anschlußebene (C,D) angeordnet ist.

7. Elektrisches Gerät nach einem der vorstehenden Ansprüche, **dadurch gekennzeichnet, daß** die Stromschienen (SM, SP) für das positive und das negative Potential sowie weitere Stromschienen (SSI) zur Signalübertragung in seitliche Ausnehmungen (42) des Basis-Klemmenträgers (2) eingesetzt sind, welche von den Anschlußebenen (A1, A2, B1, B2, ... oder A1, A2, A3,..., B1, ...) zu Anschlußöffnungen (44) zur Aufnahme eines Gerätesteckers zur Elektronikleiterplatte (14) und/oder des Randes der Elektronik-Leiterplatte (14) in der Grundwandung (52) der Ausnehmung (12) der Basis-Klemmenträger verlaufen.

8. Elektrisches Gerät nach einem der vorstehenden Ansprüche, **dadurch gekennzeichnet, daß** die Stromschiene (SPE) zur Verbindung der Schutzleiter-Potentialführung mit der Anschlußebene (C, D) für das Schutzleiterpotential (PE) vorzugsweise einstückig an die Querbrücker (40) der Schutzleiter-Potentialführung angeformt ist.

9. Elektrisches Gerät nach einem der vorstehenden Ansprüche, **dadurch gekennzeichnet, daß** über den Gerätestecker (24) und/oder die Elektronikleiterplatte das positive und das negative Potential von den Querbrückern der Potentialführung (PF+, PF-) jeweils zu einer der Anschlußöffnungen (44c, 44d) auf gegenüberliegenden Außenseiten des Basis-Klemmenträgers (2) geführt ist.

10. Elektrisches Gerät nach einem der vorstehenden Ansprüche, **dadurch gekennzeichnet, daß** die Endbereiche der Stromschienen (SFE, SSI, SM, SP, SPE) als Anschlußkontakte zum Anschluß weiterer Stromschienen oder Leiterplattenränder ausgebildet sind.

11. Elektrisches Gerät nach einem der vorstehenden Ansprüche, **dadurch gekennzeichnet, daß** an die einen Endbereiche der Stromschienen Federkontakte (36, 78) angesetzt sind und/oder daß diese Endbereiche als Schraub-, oder Steckanschlüsse ausgebildet sind.

12. Elektrisches Gerät nach einem der vorstehenden Ansprüche, **dadurch gekennzeichnet, daß** die Endbereiche der Stromschienen wenigstens an einer Seite als Stanz-/Biegeteil-Kontaktaufnahmen (45) für den Gerätestecker zur - oder den Rand der - Elektronik-Leiterplatte (14) ausgebildet sind.

13. Elektrisches Gerät nach einem der vorstehenden Ansprüche, **gekennzeichnet durch** an die Stromschienen (SM, SP, SPE) angesetzte separate vorzugsweise einstückige Verlängerungs-Stromschienen (72) zur Brückung der Potentiale zwischen den verschiedenen Anschlußebenen (..., B, C, ..., E, F,...,H,I,...) der Basis-Klemmenträger (2).

14. Elektrisches Gerät nach einem der vorstehenden Ansprüche, **dadurch gekennzeichnet, daß** die Verlängerungsstromschienen (72) jeweils um 90° verdreht an die jeweils zu verlängernden Stromschienen angesetzt sind.

15. Elektrisches Gerät nach einem der vorstehenden Ansprüche, **dadurch gekennzeichnet, daß** die Verlängerungsstromschienen (72) an einem ihrer Enden federnd ausgeführt sind, wobei die federnden Abschnitte (74) in Öffnungen (76) der jeweils zu verlängernden Stromschienen (SM, SP) eingreifen und/oder daß die Verlängerungsstromschienen (72) mit ihren Endbereichen in federnde Aufnahmebuchsen der jeweils zu verlängernden Stromschienen (SM, SP) eingreifen.

16. Elektrisches Gerät nach einem der vorstehenden Ansprüche, **dadurch gekennzeichnet, daß** die Weiterleitung der verschiedenen Potentiale innerhalb der Modulblöcke (MB) einerseits durch die Potentialführungen (PE, PF+, PF-) im unteren zur Tragschiene gewandten Bereich der Basis-Klemmenträger (2) und andererseits zwischen den Mehrfachanschlüssen einer Anschlußebene (B, C, ...) durch Querverbinderkämme (84) erfolgt, die mit Zapfen (85) versehen sind, welche in an die Stromschienen (SM, SP, SPE) angeformte federnde Aufnahmebuchsen (86) eingreifen bestehen und/oder daß die Querverbinderkämme (84) mit federnden Buchsen versehen sind, in welche an die Stromschienen angeformte Zapfen eingreifen.

17. Elektrisches Gerät nach einem der vorstehenden Ansprüche, **dadurch gekennzeichnet, daß** die Stromschienen der Potentialführungen (PF-,PF+ und/oder PE) der Modulblöcke (MB) aus verschieden langen Stromschienenabschnitten bestehen.

18. Elektrisches Gerät nach einem der vorstehenden Ansprüche, **dadurch gekennzeichnet, daß** die Verlängerungsstromschienen (72) des Modulblockes (MB) jeweils um 90° verdreht sind und an ihren Enden senkrecht nach oben Aufnahmebuchsen zur Kontaktierung der Querverbinderkämme (84) aufweisen.

19. Elektrisches Gerät nach einem der vorstehenden Ansprüche, **dadurch gekennzeichnet, daß** die um 90° verdrehten Verlängerungsstromschienen (72) von gesondert einlegbaren und/oder am Basis-Klemmenträgern angespritzten Isolierscheiben von dem Potential der Stromschiene der Anschlußebene (D) (luft- und kriechstreckenseitig) getrennt sind.

20. Elektrisches Gerät nach einem der vorstehenden Ansprüche, **dadurch gekennzeichnet, daß** der PE-Querbrücker bei den Modulblöcken (MB) senkrecht in den seitlichen Ausnehmungen (42) der Basis-Klemmenträger (2) angeordnet ist und an seinen Enden eine Aufnahmebuchse zur Kontaktierung der Querverbinderkämme (84) und eine Aufnahmebuchse nach unten zur Kontaktierung der Stromschiene (SPE) aufweist.

21. Elektrisches Gerät nach einem der vorstehenden Ansprüche, **dadurch gekennzeichnet, daß** die Querverbinderkämme (84) in das Abdeckgehäuse (46') eingesteckt sind und beim Aufsetzen des Abdeckgehäuses auf die aneinandergereihten Basis Klemmenträger (2) des Modulblockes (MB) in die Basis-Klemmenträger (2) eingreifen und jeweils wenigstens einen Kontaktabschnitt der Mehrfachanschlüsse (B, C, ...) ausbilden.

22. Elektrisches Gerät nach einem der vorstehenden Ansprüche, **dadurch gekennzeichnet, daß** die einzelnen Anschlußebenen bei plusschaltenden Initiatoren/Aktoren folgende Belegung aufweisen,
- erste Anschlußebene (A): erste Signalebene;
- zweite Anschlußebene (B): Minuspotential;
- dritte Anschlußebene (C): Pluspotential oder Schutzerde oder Schirm; und (sofern vorhanden):
- vierte Anschlußebene (D): Schutzerde oder zweite Signalebene;
- fünfte Anschlußebene (E): Minuspotential;
- sechste Anschlußebene (F): Pluspotential oder Schutzerde;
- wobei bei minusschaltenden Intiatoren/Aktoren die Plus- und Minuspotential führenden Anschlußebenen umgekehrt belegt sind.

23. Elektrisches Gerät nach einem der vorstehenden Ansprüche, **dadurch gekennzeichnet, daß** das Potential innerhalb einer Anschlußebene eines Modulblockes (MB) durch mehrere unterschiedliche lange der Querverbindungskämme (84) und beliebig in seitliche Ausnehmungen (42) der Basis-Klemmenträger (2) positionierbare Verlängerungsstromschienen variiert.

24. Elektrisches. Gerät nach einem der vorstehenden Ansprüche, **dadurch gekennzeichnet, daß** die Modulscheibe (MS) im Bereich der Umfangs-Ausnehmung (12) für die Elektronikleiterplatte (14) von außen zur Tragschiene hin folgende Funktionsbereiche aufweist:
- Modulbus(öffnung) (8),
- Kennzeichnungskanal (54),
- seitlicher Rasthaken (56),
- FE-Kontakt (Funktionserde) (58),
- Potentialführungs-Kontaktierungsöffnung (59), und
- Anschlüsse (44) zur Verbindung der Stromschienen mit einem Stecker zur Elektronik-Leiterplatte und/oder direkt mit der Leiterplatte (14).

25. Elektrisches Gerät nach einem der vorstehenden Ansprüche, **dadurch gekennzeichnet, daß** die Anschlüsse (44) zu den Anschlußebenen hin folgende Belegung aufweisen:
- Signal-Stromschienen (SSI) aus der vierten Anschlußebene (D) (Anschlüsse 44a,b);
- Plus-Minus-Stromschienen zu den Mehrfachanschlüssen (B1, B2, C1, C2) (Anschlüsse 44c,d);
- zweimal Signal-Stromschienen (SSI) aus der ersten Arischlußebene (A) (Anschlüsse 44e,f).

26. Elektrisches Gerät nach einem der vorstehenden Ansprüche, **dadurch gekennzeichnet, daß** im Bereich der Umfangs-Ausnehmung (12) neben dem FE-Kontakt (58) und der Potentialführungs-Kontaktierungsöffnung (59) eine Ausnehmung (62) für ein Kodierelement (66) vorgesehen ist.

27. Elektrisches Gerät nach einem der vorstehenden Ansprüche, **dadurch gekennzeichnet, daß** der FE-Kontakt (58) einstückig ausgeführt ist und mit seinem Endbereich direkt den Leiterplattenrand der Elektronik-Leiterplatte (14) kontaktiert.

28. Elektrisches Gerät nach einem der vorstehenden Ansprüche, **dadurch gekennzeichnet, daß** an den Rand der Leiterplatte (14) Kontaktierungs-Steckerstifte angeformt sind.

29. Elektrisches Gerät nach einem der vorstehenden Ansprüche, **dadurch gekennzeichnet, daß** wenigstens eine Öffnung (57', 57) in der Umfangs-Ausnehmung (12) für die Elektronik-Leiterplatte (14) vorgesehen ist, durch welche der seitlich aus em Basis-Klemmemträger (2) der Nachbarklemme vorkragende Rasthaken (56) mit einem Werkzeug (Schraubendreher) entriegelbar ist.

30. Elektrisches Gerät nach einem der vorstehenden Ansprüche, **dadurch gekennzeichnet, daß** der Basis-Klemmenträger (2) bei einer Auslegung mit vier Anschlußebenen (A, B, ...) mit einem unterhalb der vierten Anschlußebene (D) liegenden Querverteilungskanal (70) zur Weiterleitung eines elektrischen Potentiales, insbesondere zur individuellen Brückung von Relaiswurzeln durch einsteckbare Querverbinder, versehen ist.

31. Elektrisches Gerät nach einem der vorstehenden Ansprüche, **dadurch gekennzeichnet, daß** der Basis-Klemmenträger (2) in seinem einen von der Tragschiene abgewandt liegenden Außenbereich mit einer den Basis-Klemmenträger (2) senkrecht zu seiner Haupt-Erstreckungsebene durchdringenden Busleiteröffnung (8) zur Aufnahme des internen Busleiterabschnitts (10) versehen ist.

32. Elektrisches Gerät nach einem der vorstehenden Ansprüche, **dadurch gekennzeichnet, daß** sowohl an den Basis-Klemmenträgern (2) der Modulscheiben (MS) als auch an den stirnseitigen Basis-Klemmenträgern (2) der Modulblöcke (MB) jeweils der interne Busleiterabschnitt (10), die Potentialführungen (PF+, PF- und PE) sowie mechanische Koppelelemente wie der Rasthaken (56) zusammensteckbar sind.

33. Elektrisches Gerät nach einem der vorstehenden Ansprüche, **dadurch gekennzeichnet, daß** die Elektronik-Leiterplatte des Modulblockes (MB) mit dem Modulblock (MB) vorzugsweise über den ersten Basis-Klemmenträger des Modulblockes (MB) kommunikations- und versorgungsmäßig verbunden sind.

34. Elektrisches Gerät nach einem der vorstehenden Ansprüche, **gekennzeichnet durch** ein Gateway (GW) zum Anschluß eines externen Feldbusses, an das sich eine als Modulscheibe (MS) ausgelegte Einspeisescheibe anschließt.

35. Elektrisches Gerät nach einem der vorstehenden Ansprüche, **dadurch gekennzeichnet, daß** die Strom- und Spannungsversorgung des Gateways (GW) und der Anschlußmodule (M) über die an das Gateway (GW) angereihte Einspeisescheibe (MS) erfolgt.

36. Elektrisches Gerät nach einem der vorstehenden Ansprüche, **dadurch gekennzeichnet, daß** das Gateway (GW) einen im wesentlichen zweiteiligen Gehäuseaufbau mit zwei um 90° versetzten Leiterplattenführungen aufweist.

37. Elektrisches Gerät nach einem der vorstehenden Ansprüche, **dadurch gekennzeichnet, daß** das Gateway (GW) direkt an die Klemmenträger (2) und den internen Busleiterabschnitt (10) der Modulblöcke oder -scheiben (MB, MS) ankoppelbar ist.

38. Elektrisches Gerät nach einem der vorstehenden Ansprüche, **gekennzeichnet durch** eine Abschlußplatte mit einem einschiebbaren, separaten Endwinkel.

39. Elektrisches Gerät nach einem der vorstehenden Ansprüche, **dadurch gekennzeichnet, daß** die letzte Modulscheibe (MS) mit einem Anschluß oder Stecker versehen ist, vorzugsweise als deren EA-Modulgehäuse ausgebildet, der zur Weitergabe des internen Busleiterabschnitts (10) und/oder der Potentiale (PF-, PF+) an eine weitere Modulscheibe oder einen Modulblock gleichen Aufbaus dient, insbesondere für weitere Anschlußmodule (M) des elektrischen Gerätes ohne eigenes Gateway, die sich auf einer anderen Tragschiene befinden.

40. Elektrisches Gerät nach einem der vorstehenden Ansprüche, **dadurch gekennzeichnet, daß** die Abdeckgehäuse (46, 46') zwischen den Anschlußebenen mit Nuten zur übersichtlichen Zuordnung von Schraubendreher-Führung, Leitereinführung, farbiger Potentialmarkierung und Beschriftung eines Anschlusses bzw. zur Abgrenzung anderer Anschlußebenen und zur Aufnahme farbiger Potentialmarkierungen versehen sind.

41. Elektrisches Gerät nach einem der vorstehenden Ansprüche, **dadurch gekennzeichnet, daß** die signalführenden Stromschienen zumindest teilweise als Lichtleiterelemente ausgebildet sind.

42. Elektrisches Gerät nach einem der vorstehenden Ansprüche, **dadurch gekennzeichnet, daß** das Abdeckgehäuse (46) und das Elektronikgehäuse (29) aneinander mit ineinandergreifenden Elementen (114, 116) geführt und/oder verriegelt sind.

43. Elektrisches Gerät nach einem der vorstehenden Ansprüche, **dadurch gekennzeichnet, daß** mehrere der Basis-Klemmenträger (2) und/oder mehrere, der Anschluß- und/oder Elektronikhauben (46, 29) in scheibenartiger Auslegung nach Art einer vormontierten Einheit vor dem Aufrasten auf die Tragschiene zu einem einzigen übergreifenden Modulblock (MB) zusammenfügbar sind.

44. Elektrisches Gerät nach einem der vorstehenden Ansprüche, **dadurch gekennzeichnet, daß** wenigstens eine der Wandungen (90) des Gatewaygehäuses (88) mit einem Stützstab (110) stabilisierbar ist.

45. Elektrisches Gerät nach einem der vorstehenden Ansprüche, **dadurch gekennzeichnet, daß** der Modulblock (MB), insbesondere dessen Basis-Klemmenträger (2), aus einem durchgehenden Unterteil und darauf aufgesetzten Scheibenelementen besteht.

## Claims

1. Electrical apparatus with a modular structure for controlling and/or monitoring technical processes and/or for industrial and/or building automation, comprising at least one connection module (M), which can be placed on a carrier rail and is provided with a plurality of levels (A, B, C, D, ...) of connections (A1, A2, B1, ...) for the connection of external conductors and has a series of disc-shaped base terminal carriers (2), wherein, inside each connection module (M), an internal bus conductor (BUS) and a plurality of potential guides (PE; PF+, PF-) extend substantially parallel to the carrier rail, wherein the potential guides are preferably connected to the connection levels via busbars of the disc-shaped base terminal carriers (2) and optionally via further elements, **characterised in that** the busbars (SM, SP, SPE) for the potential supply to the connection levels ( B, C, D, ...) are distributed over the two sides of the base terminal carrier (2) and the busbars of each individual potential (SM, SP, SPE) are in each case only guided on one of the sides of the base terminal carrier (2) to the associated connections (B1, B2, ...), wherein the connections (B1, B2, ...) to be supplied by a common potential, are connected directly to one another to form multiple connections.

2. Electrical apparatus according to claim 1, **characterised in that**
- each connection module consists of module discs (MS) and/or module blocks (MB) which can be aligned in series and combined with one another as desired and which, in each case, are arranged on the base terminal carriers (2), which can be aligned in series and are designed in a disc-like or block-like manner,
- wherein the module discs (MS) and the module blocks (MB) each have at least one electronic circuit board (14), an electronic housing (29) and a cover housing (46).

3. Electrical apparatus according to claim 2, **characterised in that** the electronic printed circuit board (14), the electronic housing (29') and the cover housing (46') of the module blocks (MB) in each case overlap a plurality of the base terminal carriers (2) and the cover housing (46) and preferably the electronic printed circuit board and the electronic housing (29) of the module discs (MS) in each case preferably overlap only one of the base terminal carriers (2).

4. Electrical apparatus according to claim 2, **characterised in that**, in each case, one of the electronic printed circuit boards (14) and one of the electronic housings (29) overlap a plurality of the module discs (MS) aligned in series and/or **in that** one module block is provided with a plurality of electronic housings (29) and/or electronic printed circuit boards (14).

5. Electrical apparatus according to any one of the preceding claims, **characterised in that** the potential guides (PE, PF+, PF-) are connected from crossmembers (20, 22, 40) in through apertures (16, 18, 38), preferably in the lower region of the base terminal carriers (2) facing toward the carrier rail.

6. Electrical apparatus according to any one of the preceding claims, **characterised in that**
- two of the potential guides (PF-, PF+) are arranged for relaying a positive and a negative potential below a peripheral recess (12) for receiving the electronic printed circuit board (14) and the electronic housing (29, 29'), and **in**
- **that** a further one of the potential guides (PE) is arranged for relaying the protective conductor potential between the third and the fourth connection level (C, D).

7. Electrical apparatus according to any one of the preceding claims, **characterised in that** the busbars (SM, SP) are used for the positive and the negative potential and further busbars (SSI) for a signal transmission in lateral recesses (42) of the base terminal carrier (2), which extend from the connection levels (A1, A2, B1, B2, ... or A1, A2, A3, ..., B1, ...) to connection openings (44) for receiving an apparatus plug to the electronic printed circuit board (14) and/or the edge of the electronic printed circuit board (14) in the base wall (52) of the recess (12) of the base terminal carriers.

8. Electrical apparatus according to any one of the preceding claims, **characterised in that** the busbar (SPE) is preferably moulded integrally onto the cross-member (40) of the protective conductor potential guide, to connect the protective conductor potential guide to the connection level (C, D) for the protective conductor potential (PE).

9. Electrical apparatus according to any one of the preceding claims, **characterised in that** the positive and the negative potential are guided via the apparatus plug (24) and/or the electronic printed circuit board, from the crossmembers of the potential guide (PF+, PF-), in each case, to one of the connection openings (44c, 44d) on opposing outsides of the base terminal carrier (2).

10. Electrical apparatus according to any one of the preceding claims, **characterised in that** the end regions of the busbars (SFE, SSI, SM, SP, SPE) are configured as connection contacts for the connection of further busbars or printed circuit board edges.

11. Electrical apparatus according to any one of the preceding claims, **characterised in that** spring contacts (36, 78) are attached to the one end region of the busbars and/or that these end regions are configured as screw or plug connections.

12. Electrical apparatus according to any one of the preceding claims, **characterised in that** the end regions of the busbars, at least on one side, are configured as punched/bent part contact receivers (45) for the apparatus plug to the - or the edge of - the electronic printed circuit board (14).

13. Electrical apparatus according to any one of the preceding claims, **characterised by** separate, preferably integral extension busbars (72) attached to the busbars (SM, SP, SPE) for bridging the potentials between the various connection levels (... , B, C, ... , E, F, ... , H, I, ...) of the base terminal carriers (2).

14. Electrical apparatus according to any one of the preceding claims, **characterised in that** the extension busbars (72) are attached, in each case rotated through 90°, to the busbars to be respectively extended.

15. Electrical apparatus according to any one of the preceding claims, **characterised in that** the extension busbars (72) are designed to be resilient at one of their ends, the resilient sections (74) engaging in openings (76) of the busbars (SM, SP) to be extended in each case, and/or **in that** the extension busbars (72) engage with their end regions in resilient receiver sockets of the busbars (SM, SP) to be extended in each case.

16. Electrical apparatus according to any one of the preceding claims, **characterised in that** the relaying of the various potentials inside the module blocks (MB), on the one hand, takes place by means of the potential guides (PE, PF+, PF-) in the lower region of the base terminal carriers (2) facing toward the carrier rail and, on the other hand, between the multiple connections of a connection level (B, C, ...) by means of cross connectors (84), which are provided with pins (85), which engage in resilient receiver sockets (86) moulded onto the busbars (SM, SP, SPE) and/or **in that** the cross connectors (84) are provided with resilient sockets, into which pins moulded onto the busbars engage.

17. Electrical apparatus according to any one of the preceding claims, **characterised in that** the busbars of the potential guides (PF-, PF+ and/or PE) of the module blocks (MB) consist of busbar sections of different lengths.

18. Electrical apparatus according to any one of the preceding claims, **characterised in that** the extension busbars (72) of the module block (MB) are in each case rotated through 90°, and at their ends, vertically upwardly, have receiver sockets for contacting the cross connectors (84).

19. Electrical apparatus according to any one of the preceding claims, **characterised in that** the extension busbars (72) rotated through 90° are separated by insulating discs which are separately insertable and/or sprayed onto the base terminal carrier from the potential of the busbar of the connection level (D) (on the air and creepage path side).

20. Electrical apparatus according to any one of the preceding claims, **characterised in that** the (PE) cross-member in the module blocks (MB) is arranged vertically in the side recesses (42) of the base terminal carriers (2) and, at its ends, has a receiver socket for contacting the cross connectors (84) and a receiving socket at the bottom for contacting the busbar (SPE).

21. Electrical apparatus according to any one of the preceding claims, **characterised in that** the cross connectors (84) are inserted into the cover housing (46') and, during placing of the cover housing on the base terminal carriers (2), aligned in series, of the module block (MB) engage in the base terminal carriers (2) and in each case form at least one contact section of the multiple connections (B, C, ...).

22. Electrical apparatus according to any one of the preceding claims, **characterised in that** the individual connection levels in positive switching initiators/actuators have the following allocation,
- first connection level (A): first signal level;
- second connection level (B): negative potential;
- third connection level (C): positive potential or protective earth or screen;
and (if present):
- fourth connection level (D): protective earth or second signal level;
- fifth connection level (E): negative potential;
- sixth connection level (F): positive potential or protective earth;
- wherein, in the case of negative switching initiators/actuators, the connection levels conducting the positive and negative potential are allocated in the reverse manner.

23. Electrical apparatus according to any one of the preceding claims, **characterised in that** the potential inside a connection level of a module block (MB) varies owing to a plurality of cross connectors (84) of different lengths and extension busbars which can be positioned as desired in lateral recesses (42) of the base terminal carriers (2).

24. Electrical apparatus according to any one of the preceding claims, **characterised in that** the module disc (MS) in the region of the peripheral recess (12) for the electronic printed conductor board (14), from the outside to the carrier rail, has the following functional areas:
- module bus (opening) (8),
- identification channel (54),
- lateral latching hook (56),
- FE contact (functional earth) (58),
- potential guide contacting opening (59) and
- connections (44) for connection of the busbars with a plug to the electronic printed circuit board and/or directly to the printed circuit board (14).

25. Electrical apparatus according to any one of the preceding claims, **characterised in that** the connections (44) toward the connection levels, have the following allocations:
- signal busbars (SSI) from the fourth connection level (D) (connections 44a, b);
- positive-negative busbars to the multiple connections (B1, B2, C1, C2) (connections 44c, d);
- two signal busbars (SSI) from the first connection level (A) (connections 44e, f).

26. Electrical apparatus according to any one of the preceding claims, **characterised in that** a recess (62) is provided for a coding element (66) in the region of the peripheral recess (12) next to the FE contact (58) and the potential guide contacting opening (59).

27. Electrical apparatus according to any one of the preceding claims, **characterised in that** the FE contact (58) is integral and, with its end region, directly contacts the printed circuit board edge of the electronic printed circuit board (14).

28. Electrical apparatus according to any one of the preceding claims, **characterised in that** contacting plug pins are moulded onto the edge of the printed circuit board (14).

29. Electrical apparatus according to any one of the preceding claims, **characterised in that** at least one opening (57', 57) is provided in the peripheral recess (12) for the electronic printed circuit board (14), through which the latching hook (56) projecting laterally from the base terminal carrier (2) of the neighbouring terminal can be unlocked with a tool (screwdriver).

30. Electrical apparatus according to any one of the preceding claims, **characterised in that** the base terminal carrier (2) is provided, in a design with four connection levels (A, B, ...), with a cross distribution channel (70) located below the fourth connection level (D) for relaying an electric potential, in particular for individual bridging of relay roots through pluggable cross connectors.

31. Electrical apparatus according to any one of the preceding claims, **characterised in that** the base terminal carrier (2), in its outer region located remote from the carrier rail, is provided with a bus conductor opening (8) penetrating the base terminal carrier (2) vertically with respect to its main extension level, to receive the internal bus conductor section (10).

32. Electrical apparatus according to any one of the preceding claims, **characterised in that**, in each case, the internal bus conductor section (10), the potential guides (PF+, PF- and PE) and mechanical coupling elements such as the latching hook (56) can be connected both to the base terminal carriers (2) of the module discs (MS) and to the end base terminal carriers (2) of the module blocks (MB).

33. Electrical apparatus according to any one of the preceding claims, **characterised in that** the electronic printed circuit board of the module block (MB) is connected to the module block (MB) preferably via the first base terminal carrier of the module block (MB), in terms of communication and supply.

34. Electrical apparatus according to any one of the preceding claims, **characterised by** a gateway (GW) for connection of an external field bus, which is adjoined by a feed disc designed as a module disc (MS).

35. Electrical apparatus according to any one of the preceding claims, **characterised in that** the current and voltage supply of the gateway (GW) and the connection modules (M) takes place via the feed disc (MS) aligned with the gateway (GW).

36. Electrical apparatus according to any one of the preceding claims, **characterised in that** the gateway (GW) has a substantially two-part housing structure with two printed circuit board guides offset by 90°.

37. Electrical apparatus according to any one of the preceding claims, **characterised in that** the gateway (GW) can be coupled directly to the terminal carriers (2) and the internal bus conductor section (10) of the module blocks or discs (MB, MS).

38. Electrical apparatus according to any one of the preceding claims, **characterised by** a terminating plate with an insertable, separate end angle.

39. Electrical apparatus according to any one of the preceding claims, **characterised in that** the last module disc (MS) is provided with a connection or plug, preferably configured as the I/O module housing thereof, which is used for relaying the internal bus conductor section (10) and/or the potentials (PF-, PF+) to a further module disc or a module block of the same structure, in particular for further connection modules (M) of the electrical apparatus without their own gateway, which are located on another carrier rail.

40. Electrical apparatus according to any one of the preceding claims, **characterised in that** the cover housings (46, 46') are provided, between the connection levels, with grooves for the clear assignment of the screwdriver guide, conductor introduction, coloured potential marking and inscription of a connection or for delimiting other connection levels and for receiving coloured potential markings.

41. Electrical apparatus according to any one of the preceding claims, **characterised in that** the signal-conducting busbars are at least partially configured as light guide elements.

42. Electrical apparatus according to any one of the preceding claims, **characterised in that** the cover housing (46) and the electronic housing (29) are guided to one another with intermeshing elements (114, 116) and/or are locked.

43. Electrical apparatus according to any one of the preceding claims, **characterised in that** a plurality of the base terminal carriers (2) and/or a plurality of the connection and/or electronic hoods (46, 29) can be connected, in a disc-like design in the manner of a preassembled unit prior to latching onto the carrier rail, to form a single overlapping module block (MB).

44. Electrical apparatus according to any one of the preceding claims, **characterised in that** at least one of the walls (90) of the gateway housing (88) can be stabilised with a support rod (110).

45. Electrical apparatus according to any one of the preceding claims, **characterised in that** the module block (MB) in particular its base terminal carrier (2) consists of a continuous lower part and disc elements placed thereon.

## Revendications

1. Appareil électrique à construction modulaire pour la commande et/ou la surveillance de processus techniques et/ou pour l'automatisation dans l'industrie et le bâtiment, comprenant
au moins un module de connexion (M) pouvant être monté sur une barre porteuse et qui présente plusieurs plans (A, B, C, D ...) de connexions (A1, A2, B1, ...) pour la connexion de conducteurs extérieurs et une juxtaposition de supports de bornes de base en forme de plaque (2),
dans lequel, à l'intérieur de chaque module de connexion (M), s'étendent, sensiblement parallèlement à la barre porteuse, un conducteur bus interne (BUS) ainsi que plusieurs guides de potentiel (PE ; PF+, PF-), les guides de potentiel étant reliés aux plans de connexions, de préférence par l'intermédiaire de barres conductrices des supports de bornes de base en forme de plaque (2) et éventuellement par l'intermédiaire d'autres éléments,
**caractérisé en ce que**
les barres conductrices (SM, SP, SPE) destinées à l'amenée de potentiel aux plans de connexions (B, C, D, ...) sont réparties sur les deux côtés du support de bornes de base (2) et les barres conductrices de chaque potentiel individuel (SM, SP, SPE) passent chacune seulement sur un des côtés du support de bornes de base (2) pour atteindre les connexions correspondantes (B1, B2, ...),
cependant que les connexions (B1, B2, ...) qui doivent être alimentées avec un potentiel commun sont reliées directement entre elles pour former des connexions multiples.

2. Appareil électrique selon la revendication 1, **caractérisé en ce que**
- chaque module de connexion est composé de plaques de modules (MS) et/ou de blocs de modules (MB) qui peuvent être juxtaposés de façon arbitraire et qui peuvent être combinés entre eux, qui se montent respectivement sur les supports de bornes de base (2) pouvant être juxtaposés, lesquels sont réalisés en forme de plaques ou de blocs,
- les plaques de modules (MS) et les blocs de modules (MB) présentent chacun au moins une plaquette imprimée d'électronique (14), un boîtier d'électronique (29) et un boîtier de protection (46).

3. Appareil électrique selon la revendication 2, **caractérisé en ce que** la plaquette imprimée d'électronique (14), le boîtier d'électronique (29') et le boîtier de protection (46') des blocs de modules (MB) recouvrent chacun plusieurs supports de bornes de base (2) et le boîtier de protection (46), de même que, de préférence, la plaquette imprimée d'électronique et le boîtier d'électronique (29) des plaques de modules (MS) recouvrent de préférence chacun seulement un des supports de bornes de base (2).

4. Appareil électrique selon la revendication 2, **caractérisé en ce qu'**à chaque fois une des plaquettes imprimées d'électronique (14) et un des boîtiers d'électronique (29) recouvrent plusieurs des plaques de modules juxtaposées (MS) et/ou **en ce qu'**un bloc de modules est muni de plusieurs boîtiers d'électronique (29) et/ou plaquettes imprimées d'électronique (14).

5. Appareil électrique selon l'une des revendications précédentes, **caractérisé en ce que** les guides de potentiel (PE, PF+, PF-) sont formés par emboîtement de contacts de pontage transversaux (20, 22, 40) dans des ouvertures de passage (16, 18, 38), de préférence dans la zone inférieure des supports de bornes de base (2) qui est dirigée vers la barre porteuse.

6. Appareil électrique selon l'une des revendications précédentes, **caractérisé en ce que**
- deux des guides de potentiel (PF-, PF+) destinés à la transmission d'un potentiel positif et d'un potentiel négatif sont disposés au-dessous d'un évidement périphérique (12) destiné à loger la plaquette imprimée d'électronique (14) et le boîtier d'électronique (29, 29'), et **en ce que**
- un autre des guides de potentiel (PE) destiné à la transmission du potentiel d'un conducteur de protection est disposé entre les troisième et quatrième plans de connexions (C, D).

7. Appareil électrique selon l'une des revendications précédentes, **caractérisé en ce que** les barres conductrices (SM, SP) pour le potentiel positif et le potentiel négatif, ainsi que d'autres barres conductrices (SSI) destinées à la transmission de signaux, sont insérées dans des évidements latéraux (42) du support de bornes de base (2), évidements qui s'étendent depuis les plans de connexions (A1, A2, B1, B2 ... ou A1, A2, A3, ..., B1 ...) jusqu'aux ouvertures de connexions (44) destinées à recevoir un connecteur d'appareil pour le plaquette imprimée d'électronique (14) et/ou au bord du plaquette imprimée d'électronique (14) dans la paroi de fond (52) de l'évidement (12) du support de bornes de base.

8. Appareil électrique selon l'une des revendications précédentes, **caractérisé en ce que** la barre conductrice (SPE) destinée à la liaison du guide de potentiel du conducteur de protection au plan de connexion (C, D) pour le potentiel de conducteur de protection (PE) est de préférence formée d'une seule pièce sur les contacts de pontage transversaux (40) du guide de potentiel du conducteur de protection.

9. Appareil électrique selon l'une des revendications précédentes, **caractérisé en ce que** le potentiel positif et le potentiel négatif est transmis, par l'intermédiaire du connecteur d'appareil (24) et/ou de la plaquette imprimée d'électronique, des contacts de pontage transversaux du guide de potentiel (PF + , PF-) respectivement à une des ouvertures de connexions (44c, 44d) sur des côtés extérieurs opposés du support de bornes de base (2).

10. Appareil électrique selon l'une des revendications précédentes, **caractérisé en ce que** les zones terminales des barres conductrices (SFE, SSI, SM, SP, SPE) sont constituées comme contacts de connexion servant à connecter d'autres barres conductrices ou bords de plaquettes imprimées.

11. Appareil électrique selon l'une des revendications précédentes, **caractérisé en ce que** des contacts à ressorts (36, 78) sont fixés aux premières zones terminales des barres conductrices et/ou **en ce que** ces zones terminales sont constituées par des connexions vissées ou à broches.

12. Appareil électrique selon l'une des revendications précédentes, **caractérisé en ce que** les zones terminales des barres conductrices sont réalisées au moins sur un côté sous la forme d'éléments femelles de contact (45) constitués par des pièces découpées/pliées, pour la fiche d'appareil, ou pour le bord de la plaquette imprimée d'électronique (14).

13. Appareil électrique selon l'une des revendications précédentes, **caractérisé par** des barres conductrices (72) prolongatrices, attachées aux barres conductrices (SM, SP, SPE), séparées mais de préférence en une seule pièce avec elles, destinées à relier les potentiels entre les différents plans de connexions (..., B, C, ..., E, F, ..., H, I, ...) des supports de bornes de base (2).

14. Appareil électrique selon l'une des revendications précédentes, **caractérisé en ce que** les barres conductrices (72) prolongatrices sont montées sur les barres conductrices à prolonger, chacune tordue à 90 °.

15. Appareil électrique selon l'une des revendications précédentes, **caractérisé en ce que** les barres conductrices prolongatrices (72) sont réalisées à la façon de ressorts à l'une de leurs extrémités, les segments à ressort (74) étant engagés dans des ouvertures (76) des barres conductrices respectives à prolonger (SM, SP) et/ou **en ce que** les barres conductrices (72) prolongatrices sont engagées par leurs zones terminales dans des douilles réceptrices à ressort des barres conductrices (SM, SP) à prolonger respectives.

16. Appareil électrique selon l'une des revendications précédentes, **caractérisé en ce que** la transmission des différents potentiels à l'intérieur des blocs de modules (MB) s'effectue, d'une part, par les guides de potentiel (PE, PF + , PF-) dans la zone inférieure des supports de bornes de base (2) qui est dirigée vers la barre porteuse et, d'autre part, entre les connexions multiples d'un plan de connexions (B, C, ...) par des peignes de connexion transversaux (84) qui sont munis de doigts (85) qui s'engagent dans des douilles réceptrices (86) à ressorts formées sur les barres conductrices (SM, SP, SPE) et/ou **en ce que** les peignes de connexion transversaux (84) sont munis de douilles à ressorts dans lesquelles s'engagent des doigts venus de formage sur les barres conductrices.

17. Appareil électrique selon l'une des revendications précédentes, **caractérisé en ce que** les barres conductrices des guides de potentiel (PF-, PF + et/ou PE) des blocs de modules (MB) sont composées de tronçons de barres conductrices de différentes longueurs.

18. Appareil électrique selon l'une des revendications précédentes, **caractérisé en ce que** les barres conductrices (72) prolongatrices du bloc de modules (MB) sont tordues chacune de 90 ° et présentent à leurs extrémités des douilles de réception dirigées verticalement vers le haut pour la mise en contact des peignes de connexion transversaux (84).

19. Appareil électrique selon l'une des revendications précédentes, **caractérisé en ce que** les barres conductrices (72) prolongatrices, tordues de 90 °, sont séparées du potentiel de la barre conductrice du plan de connexions (D) (du côté de l'air ou de la ligne de fuite) par des barres isolantes qui peuvent être mises en place séparément et/ou qui sont formées par injection sur les supports de bornes de base.

20. Appareil électrique selon l'une des revendications précédentes, **caractérisé en ce que** le contact de pontage transversal PE prévu sur les blocs de modules (MB) est disposé perpendiculairement dans les évidements latéraux (42) des supports de bornes de base (2) et il présente à ses extrémités une douille de réception pour la mise en contact du peigne de connexion transversal (84) et une douille de réception dirigée vers le bas pour la mise en contact de la barre conductrice (SPE).

21. Appareil électrique selon l'une des revendications précédentes, **caractérisé en ce que** les peignes de connexion transversaux (84) sont embrochés dans le boîtier de protection (46') et, lors de la pose du boîtier de protection sur les supports de bornes de base juxtaposés (2) du bloc de modules (MB), ils s'engagent dans les supports de bornes de base (2) et forment à chaque fois au moins un segment de contact des connexions multiples (B, C, ...).

22. Appareil électrique selon l'une des revendications précédentes, **caractérisé en ce que**, dans le cas d'initiateurs/actionneurs à commutation positive, les différents plans de connexions présentent l'occupation suivante :
- premier plan de connexions (A) : premier plan de signaux ;
- deuxième plan de connexions (B) : potentiel négatif ;
- troisième plan de connexions (C) : potentiel positif ou terre de protection ou blindage ;
et (s'ils sont présents) :
- quatrième plan de connexions (D) : terre de protection ou deuxième plan de signaux ;
- cinquième plan de connexions (E) : potentiel négatif ;
- sixième plan de connexions (F) ; potentiel positif ou terre de protection ;
et, dans le cas d'initiateurs/actionneurs à commutation négative, les plans de connexions conduisant le potentiel positif et le potentiel négatif présentent des occupations inversées.

23. Appareil électrique selon l'une des revendications précédentes, **caractérisé en ce que** le potentiel à l'intérieur du plan de connexions d'un bloc de module (MB) varie sous l'effet de différences de longueur des peignes de connexion transversaux (84) et des barres conductrices (72) prolongatrices qui peuvent être positionnées arbitrairement dans des évidements latéraux (42) des supports de bornes de base (2).

24. Appareil électrique selon l'une des revendications précédentes, **caractérisé en ce que** la plaque de module (MS) présente, dans la zone de l'évidement périphérique (12) pour la plaquette imprimée d'électronique (14) en allant de l'extérieur vers la barre porteuse, les zones fonctionnelles suivantes :
- bus de module (ouverture) (8),
- canal de repérage (54),
- crochet d'encliquetage latéral (56),
- contact de FE (terre de fonction) (58),
- ouverture de guide de potentiel - mise en contact (59), et
- connexions (44) pour le raccordement des barres conductrices avec un connecteur sur la plaquette imprimée d'électronique et/ou directement avec la plaquette imprimée (14).

25. Appareil électrique selon l'une des revendications précédentes, **caractérisé en ce que** les connexions (44) sur les plans de connexions présentent l'occupation suivante :
- barres conductrices et de signaux (SSI) en partant du quatrième plan de connexions (D) (connexions 44a, b) ;
- barres conductrices positives-négatives vers les connexions multiples (B1, B2, C1, C2) (connexions 44c, d) ;
- deux fois les barres conductrices et de signaux (SSI) en partant du premier plan de connexions (A) (connexions 44e, f).

26. Appareil électrique selon l'une des revendications précédentes, **caractérisé en ce que**, dans la zone de l'évidement périphérique (12), il est prévu un évidement (62) pour un élément encodeur (66) en supplément du contact FE (58) et de l'ouverture de guide de potentiel-mise en contact (59).

27. Appareil électrique selon l'une des revendications précédentes, **caractérisé en ce que** le contact FE (58) est réalisé en une seule pièce et est mis directement en contact avec le bord de la plaquette imprimée d'électronique (14) par sa zone terminale.

28. Appareil électrique selon l'une des revendications précédentes, **caractérisé en ce que** des broches de connexion de mise en contact sont formées sur le bord de la plaquette imprimée (14).

29. Appareil électrique selon l'une des revendications précédentes, **caractérisé en ce qu'**il est prévu dans l'évidement périphérique (12) au moins une ouverture (57', 57) pour la plaquette imprimée d'électronique (14), ouverture à travers laquelle un crochet d'encliquetage (56) qui émerge latéralement du support de bornes de base (2) de la borne voisine peut être déverrouillé avec un outil (tournevis).

30. Appareil électrique selon l'une des revendications précédentes, **caractérisé en ce que** le support de bornes de base (2), lorsqu'il est réalisé avec quatre plans de connexions (A, B, ...), est pourvu d'un canal de répartition transversale (70) qui se trouve au-dessous du quatrième plan de connexions (D), pour transmettre un potentiel électrique, en particulier pour le pontage individuel de racines de relais par des connecteurs transversaux embrochables.

31. Appareil électrique selon l'une des revendications précédentes, **caractérisé en ce que** le support de bornes de base (2) est muni, dans sa zone extérieure qui est éloignée de la barre porteuse, d'une ouverture de conducteur bus (8) qui traverse le support de bornes de base (2) perpendiculairement à son plan d'extension principal, pour recevoir le tronçon interne (10) du conducteur bus.

32. Appareil électrique selon l'une des revendications précédentes, **caractérisé en ce qu'**aussi bien sur les supports de bornes de base (2) des plaques de modules (MS) que sur les supports de bornes de base (2) frontaux des blocs de modules (MB), peuvent être embrochés, à chaque fois le tronçon interne (10) du conducteur bus, les guides de potentiel (PF+, PF- et PE) ainsi que des éléments d'accouplement mécanique tels que le crochet d'encliquetage (56).

33. Appareil électrique selon l'une des revendications précédentes, **caractérisé en ce que** la plaquette imprimée d'électronique du bloc de modules (MB), avec le bloc de modules (MB), sont connectés pour la communication et l'alimentation, de préférence par l'intermédiaire du premier support de bornes de base du bloc de module (MB).

34. Appareil électrique selon l'une des revendications précédentes, **caractérisé par** une interface (GW) pour la connexion d'un bus de champ auquel fait suite une plaque d'alimentation constituée par une plaque de module (MS).

35. Appareil électrique selon l'une des revendications précédentes, **caractérisé en ce que** l'alimentation en courant et en tension de l'interface (GW) et des modules de connexion (M) s'effectue par l'intermédiaire de la plaque d'alimentation (MS) juxtaposée à l'interface (GW).

36. Appareil électrique selon l'une des revendications précédentes, **caractérisé en ce que** l'interface (GW) présente une structure en bottier, sensiblement en deux parties, qui possède deux guides de plaquette imprimée décalés de 90°.

37. Appareil électrique selon l'une des revendications précédentes, **caractérisé en ce que** l'interface (GW) peut être directement accouplée aux supports de bornes (2) et au tronçon de conducteur bus interne (10) des blocs ou plaques de modules (MB, MS).

38. Appareil électrique selon l'une des revendications précédentes, **caractérisé par** une plaque de fermeture munie d'une équerre terminale séparée, pouvant être emmanchée.

39. Appareil électrique selon l'une des revendications précédentes, **caractérisé en ce que** la dernière plaque de module (MS) est munie d'une connexion ou d'un connecteur, constitué de préférence par son boîtier de module EA, qui sert pour la prolongation du tronçon de conducteur bus interne (10) ou des potentiels (PF-, PF +) vers une autre plaque de module ou à un bloc de modules de même construction, en particulier pour d'autres modules de connexion (M) de l'appareil électrique sans interface propre, qui se trouvent sur une autre barre porteuse.

40. Appareil électrique selon l'une des revendications précédentes, **caractérisé en ce que** les boîtiers de protection (46, 46') situés entre les plans de connexions sont munis de rainures pour créer une correspondance visible de guides de tournevis, d'insertion de conducteurs, de marquages de potentiels colorés et de l'inscription d'une connexion, ou encore pour délimiter d'autres plans de connexions et pour recevoir des marquages de potentiels colorés.

41. Appareil électrique selon l'une des revendications précédentes, **caractérisé en ce que** les barres conductrices conduisant des signaux sont constituées au moins partiellement par des guides optiques.

42. Appareil électrique selon l'une des revendications précédentes, **caractérisé en ce que** le boîtier de protection (46) et le boîtier d'électronique (29) sont guidés et/ou verrouillés l'un contre l'autre au moyen d'éléments (114, 116) qui s'engagent les uns dans les autres.

43. Appareil électrique selon l'une des revendications précédentes, **caractérisé en ce que** plusieurs des supports de bornes de base (2) et/ou plusieurs des capots de connexions et/ou d'électronique (46, 29) d'une construction en forme de plaque, à la façon d'une unité pré-montée, peuvent être assemblés en un unique bloc recouvrant de modules (MB) avant l'encliquetage sur la barre porteuse.

44. Appareil électrique selon l'une des revendications précédentes, **caractérisé en ce qu'**au moins une des parois (90) du boîtier d'interface (88) peut être stabilisée au moyen d'une barre de support (110).

45. Appareil électrique selon l'une des revendications précédentes, **caractérisé en ce que** le bloc de modules (MB), en particulier son support de bornes de base (2), est composé d'une partie inférieure continue et d'éléments en plaques montés sur cette dernière.
